Europäisches Patentamt

European Patent Office

Office européen des brevets

(19)

(11) Publication number: **0 071 912**
**B1**

(12) **EUROPEAN PATENT SPECIFICATION**

(45) Date of publication of patent specification: **26.11.86**

(51) Int. Cl.⁴: **G 01 R 19/25**

(21) Application number: **82106917.6**

(22) Date of filing: **30.07.82**

(54) **Measurement apparatus.**

(30) Priority: 30.07.81 JP 118412/81
30.07.81 JP 118413/81
30.07.81 JP 118414/81
30.07.81 JP 118415/81
30.07.81 JP 118416/81
30.07.81 JP 118417/81
03.08.81 JP 120723/81
03.08.81 JP 120724/81
15.08.81 JP 127336/81
26.08.81 JP 132750/81
28.08.81 JP 134224/81
28.08.81 JP 134225/81

(43) Date of publication of application:
**16.02.83 Bulletin 83/07**

(45) Publication of the grant of the patent:
**26.11.86 Bulletin 86/48**

(84) Designated Contracting States:
**CH DE FR GB IT LI**

(56) References cited:
**AT-B- 291 387
CH-A- 617 510
DE-A-2 915 522**

(73) Proprietor: **FUJI ELECTRIC CO. LTD.**
**1-1, Tanabeshinden, Kawasaki-ku
Kawasaki 210 (JP)**

(72) Inventor: **Yasuhara, Takeshi
7-20, Kita-4-chome Asagaya
Suginami-ku, Tokyo 166 (JP)**
Inventor: **Nabeta, Eiichi
205, Matsuba-Corpo, 5-35-9 Honchoh
Koganei-shi, Tokyo 184 (JP)**

(74) Representative: **Blumbach Weser Bergen
Kramer Zwirner Hoffmann Patentanwälte
Radeckestrasse 43
D-8000 München 60 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 071 912 B1

## Description

The present invention relates to a measurement apparatus according to the first portion of claim 1.

There have been well-known and widely practiced methods for detecting a physical change such as a frequency, voltage, electrical resistance, or electrostatic capacity change. Many measurement apparatus for effecting such methods have had limitations on measuring accuracy, for example, since a detected output is subjected to analog signal processing before a final output signal is obtained.

One known transducer for converting a physical quantity into a frequency is a vortex-shedding flowmeter utilizing a von Kármán vortex stream pattern.

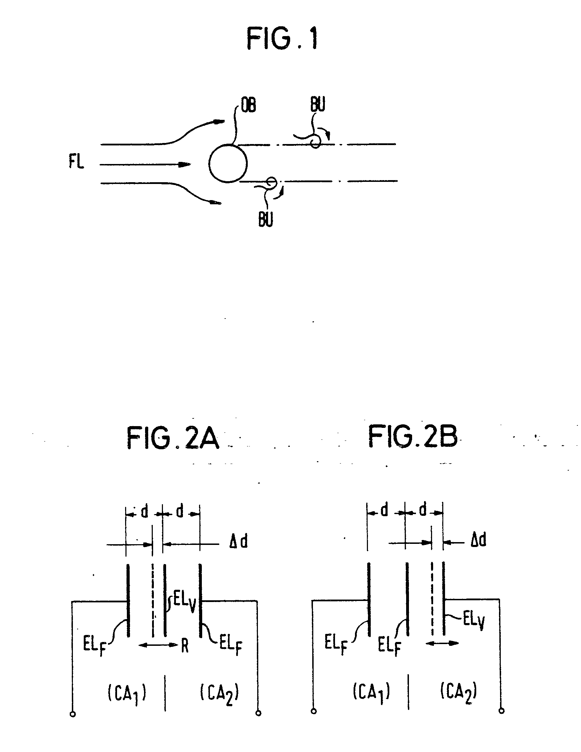

Fig. 1 is illustrative of the principles of such a vortex-shedding flowmeter, the figure being a schematic plan view showing a column-shaped vortex-shedding body OB placed in a fluid flow FL. As is well-known, vortices BU are alternately generated downstream of the vortex-shedding body OB one on each side thereof to produce alternate pressure differences on both sides of the vortex-shedding body OB such that the pressure on the side where a vortex is generated is lower than that on the side where no vortex is formed. Such a pressure difference is conveyed via an opening or pressure transmission port (not shown) into a vibratory chamber in the vortex-shedding body OB or outside thereof for vibrating a vibratory plate in the vibratory chamber. The number of vortices or the frequency F of generation of vortices which are alternately generated on the sides of the vortex-shedding body can be expressed as:

$$F = k \cdot V/D \qquad (1)$$

where V is the rate of fluid flow, D is the diameter of the vortex-shedding body, and k is a constant. The flow rate or the volume of the fluid as it flows can be derived from the frequency F thus calculated.

A signal indicative of such a frequency has heretofore been converted into a voltage signal by a frequency-to-voltage (F/V) converter, and the voltage signal has then been converted into current signal ranging from 4 to 20 mA to thereby effect measurements. However, the known measurement apparatus rely on analog circuits and thus are susceptible to measurement errors and have limited measuring accuracy.

Thermocouples or thermoresistances such as a thermistor for temperature measurement have been widely used as elements for converting a physical quantity into a voltage or resistance for detection of the physical quantity. It has been general practice to use an operational amplifier or the like to amplify a thermoelectromotive force generated by the thermocouple or a voltage drop across the thermoresistance, and derive a resistance from an output from the operational amplifier. Such a measurement apparatus is also composed of an analog circuit and thus tends to cause measurement errors, resulting in low measuring accuracy. The thermocouple or thermoresistance has a non-linear temperature vs. thermoelectromotive force or temperature vs. resistance characteristic, so that the measurement apparatus needs additional means for linearizing such a non-linear characteristic.

Transducers for converting a physical quantity into a corresponding capacitance include a differential-pressure or pressure sensor comprising a diaphragm which is displaceable under a differential pressure or a pressure, and a movable electrode such as a capacitor attached to the diaphragm. The principles of operation of such a pressure sensor will now be described with reference to Figs. 2(A) and 2(B). In Fig. 2(A), a movable electrode $EL_V$ is disposed between two fixed electrodes $EL_F$, the movable electrode $EL_V$ being movable laterally in the directions of the arrow R in response to a change in a physical quantity such as a pressure or a mechanical quantity. When the movable electrode $EL_V$ is thus displaced, one of capacitances $CA_1$, $CA_2$ between the electrodes is increased and the other capacitance is reduced accordingly. Thus, the capacitances are varied differentially. Assuming that the area of each electrode is S, the dielectric constant between the electrodes is $\varepsilon$, and the distance between the movable electrode $EL_V$ and each of the fixed electrodes $EL_F$ is d, the capacitances $CA_1$, $CA_2$ when the movable electrode $EL_V$ is displaced $\Delta d$ to the position shown by the dotted line in Fig. 2(A) can be given as follows:

$$CA_1 = \varepsilon A/(d - \Delta d)$$

$$CA_2 = \varepsilon A/(d + \Delta d)$$

The addition of and difference between the capacitances are given by the following equations:

$$CA_1 + CA_2 = \varepsilon A \cdot 2d/(d^2 - (\Delta d)^2)$$

$$CA_1 - CA_2 = \varepsilon A \cdot 2\Delta d/(d^2 - (\Delta d)^2)$$

The ratio between the addition and the difference is expressed by:

$$(CA_1 - CA_2)/(CA_1 + CA_2) = \Delta d/d \qquad (2)$$

Thus, the displacement $\Delta d$ can be derived from the capacitance ratio

$$(CA_1 - CA_2)/(CA_1 + CA_2).$$

In Fig. 2(B), two fixed electrodes $EL_F$ are disposed adjacent to one another, and a movable electrode $EL_V$ is positioned adjacent to one of the fixed electrodes $EL_F$. When the movable electrode $EL_V$ is displaced $\Delta d$ to the position shown by the dotted line in Fig. 2(B), the capacitances $CA_1$, $CA_2$, the former being fixed and the latter variable, can be expressed by:

$$CA_1=\varepsilon A/d, \quad CA_2=\varepsilon A/(d+\Delta d)$$

The difference between the two capacitances is given by:

$$CA_1-CA_2=\varepsilon A \cdot \Delta d/d(d+\Delta d)$$

The ratio of $CA_1-CA_2$ to $CA_2$ is given by:

$$(CA_1-CA_2)/CA_2=\Delta d/d \qquad (3)$$

Thus, the displacement $\Delta d$ can be detected as a change in the electrostatic capacity.

It has been customary when detecting such a capacitance to apply a high-frequency a—c voltage to a capacitor to be measured, derive an electrostatic capacity from a current flowing through the capacitor which is proportional to the frequency, power supply voltage and capacitance, and amplify and effect arithmetic operations on a detected current with a differential amplifier or the like for conversion into the displacement. Such a prior practice relies on an analog circuit, which produces an output that is susceptible to large variations due to disturbances such as noises and temperatures, and hence is of limited measuring accuracy. Furthermore, since the impedance such as capacitance or resistance is affected by the power supply frequency or voltage, the known apparatus is liable to cause measuring errors when subjected to variations in the power supply voltage or frequency.

A measurement apparatus as defined in the first portion of claim 1 has been known from the document DE—A—29 25 522. This document describes the measurement of the thickness of a wall by means of an ultrasonic pulse. A clock circuit operates an ultrasonic pulse generator to deliver a pulse to an ultrasonic probe. At the same time, the clock circuit sets a flipflop. The reflected ultrasonic wave received by the probe is detected by a receiver which delivers a detecting signal resetting said flipflop. The output of the flipflop thus corresponds to the time interval between transmitting the ultrasonic wave and receiving the reflected wave. The output from the flipflop controls an AND-gate which receives clock pulses as a second input signal. By means of this AND-gate the period of the flipflop output corresponding to the thickness to be measured is converted into a corresponding number of clock pulses. The number of clock pulses passed by the AND-gate is counted by an up/down counter which forms part of a digital processing circuit. The digital processing circuit is to average the results of a plurality of outputs from the said flipflop.

Another measurement apparatus for converting a physical quantity into a digital quantity is described in AT—B—291 387. In this case the physical quantity to be measured is converted into a pulse signal having a frequency corresponding to the physical quantity. This pulse signal is input as one input signal to an AND-gate.

Another input signal to the AND-gate is a clock pulse signal provided via a frequency divider. The output from the AND-gate is supplied to a counter counting the pulses of the pulse signal passed through the AND-gate within a period defined by the clock pulse signal from the frequency divider.

It is an object of the invention to provide a measurement apparatus allowing to convert a physical quantity into a digital quantity with a high accuracy.

This object is achieved with a measurement apparatus as claimed.

The measurement apparatus according to the invention is suitable for use in applications in which a pulse signal with a frequency dependent on a physical quantity is obtained directly. A measurement apparatus according to the invention and suitable for such uses in which a physical quantity is first detected as a voltage, resistance, or capacitance signal with a magnitude corresponding to the physical quantity is defined in claims 2 through 4. The measurement apparatus also needs to be capable of easy zero and spanning adjustment. To meet such a requirement, the measurement apparatus may be constructed as described in claim 5.

The measurement apparatus as described in claim 1 may be used in a measurement apparatus system in combination with means having an electric-to-optical transducer for converting a result of measurement into optical information and delivering such optical information to an upper processor as claimed in claim 6.

A measurement apparatus using electro-optic and opto-electric conversion at the transmitting unit is described and claimed is the Divisional Application 84114777.0 (EP—159401), published 30.10.85.

The measurement apparatus can meet the following requirements. First, transmission on a time-sharing multiplex basis should be effected between a single central processing unit and a plurality of measurement apparatus to thereby reduce the cost of a transmission path. Secondly, the measurement apparatus should operate only when necessary to reduce the electric power consumption of the apparatus. The third requirement is that optical parts in an optical transmission circuit be pinned for their failures. According to the fourth requirement, light-emitting elements in the optical transmission circuit should be prevented from being energized accidentally. The fifth requirement is that when the light-emitting and light-receiving elements in the central processing unit and the measurement apparatus, and the transmission path suffer from any trouble, the position at which the trouble is caused, should be detected. The above requirements may easily be met by the measurement apparatus as described in claim 2 through 11.

The measurement apparatus as described in claim 1 can be combined with means for converting a result of measurement into a current signal and delivering such a current signal as claimed in claim 13.

The present invention will now be described in more detail with reference to the drawings, in which:

Fig. 1 is a schematic view of a known vortex-shedding flowmeter for generating a pulse signal having a frequency dependent on a flow rate of a fluid;

Figs. 2(A) and 2(B) are schematic views of known detectors for producing a capacitive (electrostatic capacity) signal dependent on mechanical displacement;

Fig. 3 is a block diagram of a measurement apparatus according to the present invention for directly generating a pulse signal having a frequency dependent on a physical quantity;

Fig. 4 is a circuit diagram of the measurement apparatus shown in Fig. 3;

Fig. 5 is a block diagram of a measurement apparatus according to the present invention for detecting a physical quantity first as a corresponding voltage signal;

Fig. 6 is a circuit diagram of the measurement apparatus shown in Fig. 5;

Fig. 7 is a waveform diagram illustrative of measuring operations of the measurement apparatus of Fig. 6;

Fig. 8 is a circuit diagram of a measurement apparatus according to the present invention for detecting a physical quantity first as a corresponding resistance signal;

Fig. 9 is a waveform diagram illustrative of measuring operations of the measurement apparatus of Fig. 8;

Fig. 10 is a circuit diagram of a measurement apparatus which is a modification of that shown in Fig. 8;

Fig. 11A is a schematic diagram showing the way in which a mechanical displacement is converted into a resistance by a wire strain gauge;

Fig. 11B is a circuit diagram of a modified measurement apparatus combined with a wire strain gauge, the measurement apparatus being a modification of that shown in Fig. 8;

Fig. 12 is a circuit diagram of a measurement apparatus of the invention for detecting a physical quantity first as a corresponding capacitive signal;

Fig. 13 is a circuit diagram of a measurement apparatus which is a modification of that illustrated in Fig. 12;

Fig. 14 is a block diagram of a system in which a plurality of measurement apparatus are connected to a central processing unit;

Fig. 15 is illustrative of forms of information transmitted between the central processing unit and the measurement apparatus in the system shown in Fig. 14;

Fig. 16 is a timing chart for information transmitting operations in the system of Fig. 14;

Fig. 17 is a flowchart for information transmitting operations in the system of Fig. 14;

Fig. 18 is a timing chart explanatory of intermittent energization of a single measurement apparatus coupled to a central processing unit;

Fig. 19 is a timing chart explanatory of intermittent energization of $n$ measurement apparatus coupled to a central processing unit;

Fig. 20 is a block diagram of a system in which the failures of optical parts in an optical transmission circuit can be detected;

Fig. 21 is a timing chart illustrative of a failure detecting operation of the system shown in Fig. 20;

Fig. 22 is a block diagram of a system in which troubles can be located;

Fig. 23 is a block diagram of a measurement apparatus according to the present invention for producing a current as an output signal; and

Fig. 24 is a circuit diagram of the measurement apparatus shown in Fig. 23.

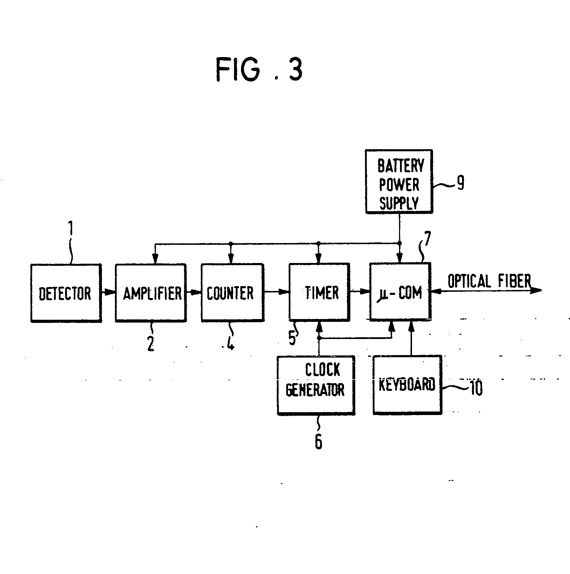

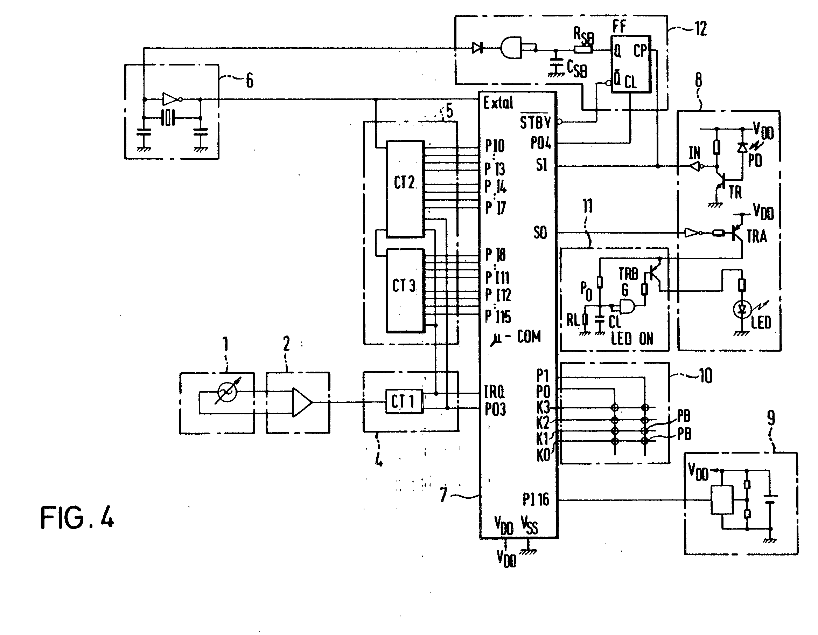

According to an embodiment of the present invention, a measurement apparatus is provided to convert into a digital signal a pulse signal having a frequency dependent on a physical quantity and generated directly by a suitable means, and for effecting predetermined arithmetic operations on the digital quantity to thereby measure the physical quantity. Such a measurement apparatus will be described with reference to a block diagram of Fig. 3 and a circuit diagram of Fig. 4.

As shown in Fig. 3, the measurement apparatus comprises a frequency detector 1, an amplifier 2, a counter 4, a timer 5, a reference clock generator circuit 6, a digital processor 7 such as a microprocessor (hereinafter referred to as "μ-COM processing circuit"), a battery power supply circuit 9, and a keyboard 10.

As illustrated in Fig. 4, the frequency detector 1 may comprise, for example, a frequency detecting device utilizing a von Kármán vortex stream pattern. The amplifier 2 may comprise an amplifier for amplifying a frequency signal as detected by the detector 1. The timer 5 is composed of two-stage counters CT2, CT3 for starting the counting of the clock pulses of a clock signal generated by the reference clock generator circuit 6 when a reset signal PO3 from the μ-COM processing circuit 7 is released, and for stopping the counting operation in response to a count-up signal supplied by the counter 4 (CT1). The μ-COM processing circut 7 is powered by the battery power supply circuit 9 and is driven by the clock signal from the reference clock generator circuit 6 to effect various arithmetic operations and control operations. When no measurement is effected, for example, the μ-COM processing circuit 7 is responsive to the reset signal PO3 to reset the counter 4 and the timer 5. Conversely, when a measurement is to be carried out, the μ-COM processing circuit 7 releases the reset signal PO3 to enable the counter 4 and the timer 5 to start their counting operations. The μ-COM processing circuit 7 then receives the count-up signal from the counter 4 as an interrupt signal IRQ, reads the count from the timer 5 through terminals PI0—PI15, and effects predetermined arithmetic operations on read information to thereby measure a physical quantity. Connected to the μ-COM processing circuit 7 are the keyboard 10 to control zero point and spanning adjustment to prevent measuring errors, an optical transmission circuit 8 having a light-emitting element LED and a light-receiving element PD for optically transmitting information to or receiving information from an upper processor or computer (not shown) in a control room, a standby mode circuit 12 for intermittently energizing the reference clock generator circuit 6 or the μ-COM processing circuit 7 to save electric power, and a detector circuit 11 for detecting accidental energization (continued energization) of the light-emitting element LED in the optical transmission circuit 8. These components connected to the μ-COM processing circuit 7 will be described later on. The battery power supply circuit 9 also serves to supply electric power to various parts shown in Fig. 4.

Operation of the measurement apparatus will be described.

In response to the release of the reset signal PO3 by the μ-COM arithmetic circuit, the counter 4 and timer 5 start operating. More specifically, timer 5 starts counting clock pulses supplied from the reference clock generator circuit 6. The counter 4 starts counting a frequency signal as detected by detector 1 and amplified by amplifier 2. When counter 4 counts a predetermined number (N), it supplies a count-up signal to the timer 5 to stop counting the clock pulses therein, and at the same time supplies such a count-up signal to the μ-COM processing circuit 7 as the interrupt signal IRQ to instruct the μ-COM processing circuit 7 that the counter 4 has completed its counting operation. In response to receiving the interrupt signal IRQ, the μ-COM processing circuit 7 reads a count (T) from the timer 5 through the terminals PI0—PI15, effects predetermined arithmetic operations on the received count for thereby measuring a physical quantity which has been detected as being converted into the frequency signal. Counting the frequency signal N times in the counter 4 serves to increase resolution of the counters CT2, CT3, and the number N may be selected depending on the frequency of the output pulses from the reference clock generator circuit 6. The frequency F can thus be determined by measuring the number of clock pulses which have been counted by the timer 5 before the counter 4 counts the number N, or by measuring the time T required by the timer 5 to count the clock pulses. The frequency F can be given by the following equation:

$$F = N/T \qquad (4)$$

With the foregoing arrangement, a physical quantity which has been converted into a frequency signal is again converted by the timer and the counter into a digital quantity, and predetermined arithmetic operations are effected on the converted digital output to measure the physical quantity. The measurement apparatus is of much higher measuring accuracy than that of conventional measurement apparatus relying on analog circuits.

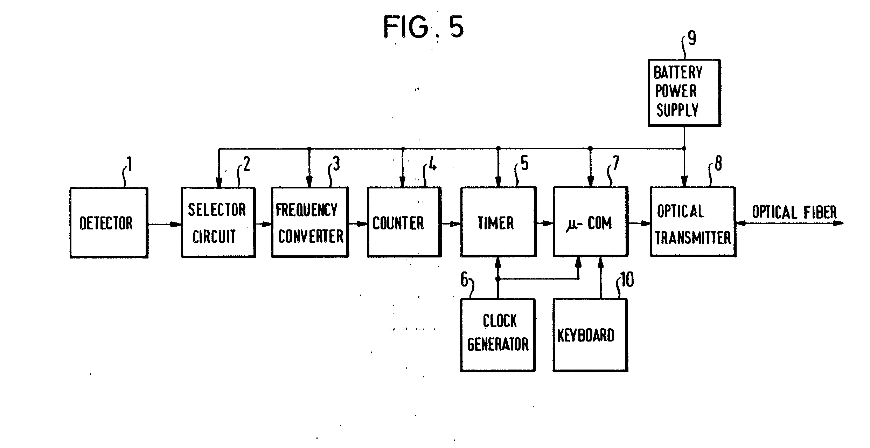

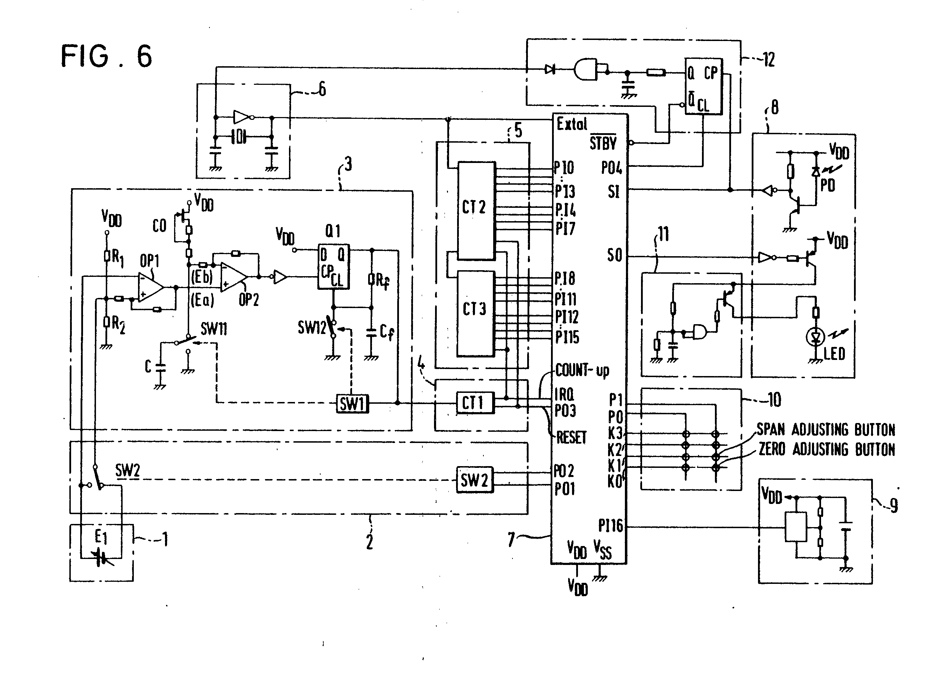

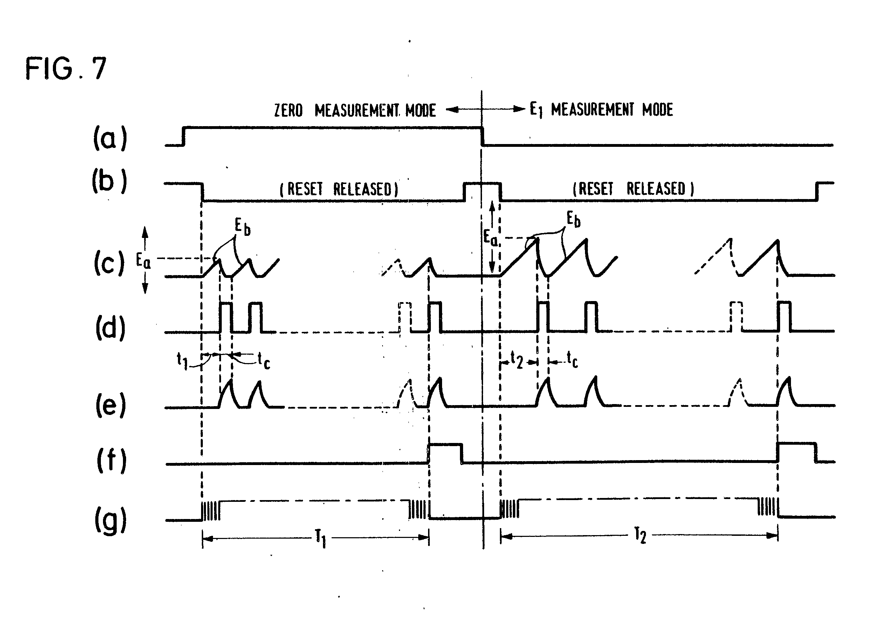

A measurement apparatus according to another embodiment will be described with reference to a block diagram of Fig. 5, a circuit diagram of Fig. 6, and a waveform diagram of Fig. 7. The measurement apparatus finds use in applications in which a physical quantity is first detected as a voltage signal with a magnitude corresponding to the physical quantity.

As shown in Fig. 5, the measurement apparatus includes a voltage detector 1, a selector circuit 2 for the detector 1, a frequency converter circuit 3, a counter 4, a timer 5, a reference clock generator circuit 6, a digital processing circut 7 such as a microprocessor (hereinafter referred to as "μ-COM processing circuit"), an optical transmission circuit 8, a battery power supply circuit 9, and a keyboard 10.

Fig. 6 shows the voltage detector 1, the detector selector circuit 2, and the frequency converter circuit 3, with the other parts 4—12, being the same as shown in Fig. 4. The μ-COM processing circuit 7 is shown to indicate additional terminals.

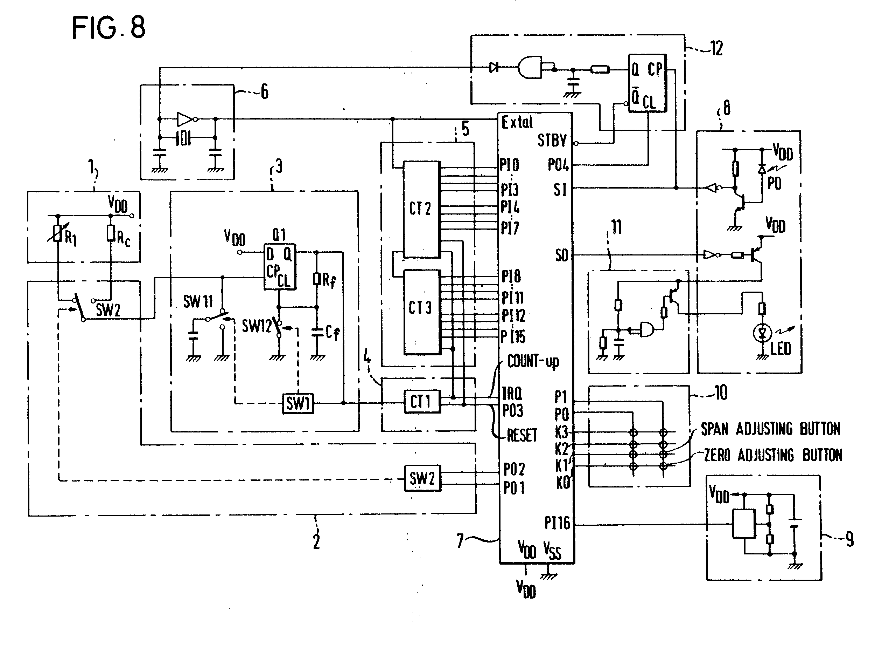

As illustrated in Fig. 6, the detector 1 may comprise a thermocouple, for example, and the selector circuit 2 may comprise a switch SW2 (such as a complementary MOS analog switch or relay) for switching conditions of the detector 1. The frequency converter circuit 3 is composed of a capacitor C which is chargeable by a constant current flowing from a constant current source CO an operational amplifier OP2 for comparing a voltage Eb to charge the capacitor C and a detected voltage Ea as amplified by an operational amplifier OP1 and for producing an output when the charging voltage Eb is equal to or greater than the detected voltage Ea, a D-type flip-flop Q1 which can be set by the output from the operational amplifier OP2 at a predetermined level (threshold level) and can be reset after expiration of a predetermined interval determined by a time constant (the product of a resistance Rf and a capacitance Cf), and a switch SW1 (switches SW11, SW12) for actuating the charging and discharging of the capacitors C and Cf. Where an ordinary D-type flip-flop is used for the flip-flop Q1, it is necessary to provide a special circuit such as a Schmitt trigger in front of the flip-flop to determine the threshold level. Such an additional circuit may, however, be dispensed with if a CMOS flip-flop is employed, with its switching voltage being used as the threshold voltage. This applies as well for flip-flops Q1 as shown in Figs. 8, 12 and 24. The switch SW1 is of the same construction as that of the switch SW2. The μ-COM arithmetic circuit 7 supplies mode selection signals PO1, PO2 to the switch SW2 in the selector circuit 2 for selection between a measurement mode (hereinafter referred to as "zero measurement mode") in which no detected voltage $E_1$ is applied, and a detected voltage $E_1$

measurement mode (hereinafter referred to as "$E_1$ measurement mode").

Measuring operations of the measurement apparatus will be described with reference to Figs. 6 and 7.

In an initial condition, no mode selection signal PO1, PO2 is delivered from the μ-COM processing circuit 7, and the counter 4 (CT1) and timer 5 remain reset by a reset signal PO3. When a zero measurement mode signal as shown at (a) in Fig. 7 is supplied to release the reset signal as shown at (b) in Fig. 7, the capacitor C is charged as shown by Eb at (c) in Fig. 7 by a constant current (I) flowing from the constant-current generating circuit CO. In the zero measurement mode, the switch SW2 is moved to a position opposite the position shown in Fig. 6, so that no measured voltage E1 is applied. A certain voltage (K2VDD), produced by dividing a power supply voltage VDD with resistors $R_1$, $R_2$, is applied to an input of the operational amplifier OP1, which applies an output voltage K1K2VDD (K1 being the gain of the operational amplifier OP1) to an input of the operational amplifier OP2. Assuming that the voltage K1K2VDD is expressed as Ea and the charging voltage for the capacitor C is Eb the operational amplifier OP2 compares these voltages Ea, Eb. When Eb≧Ea, the operational amplifier OP2 produces an output to set the flip-flop Q1. The relationship between the voltages Ea, Eb is shown at (c) in Fig. 7. When the flip-flop Q1 is set, the output thereof is applied to the counter 4-(CT1) and switch SW1. As a result, the switch SW12 is opened to complete a charging circuit composed of resistor Rf and capacitor Cf. At this time, the switch SW11 will be shifted to a position opposite to that shown in Fig. 6 for allowing the capacitor C to be discharged. When the charging voltage for the capacitor Cf reaches a predetermined level after a time interval $t_c$ as illustrated at (e) in Fig. 7, the flip-flop Q1 is cleared, and consequently it produces an output pulse having the width ($t_c$) as shown at (d) in Fig. 7. When the flip-flop Q1 is reset, the analog switch SW1 is turned off to return the switches SW11, SW12 to the illustrated positions in Fig. 6, whereupon the switch SW11 makes a charging circuit for the capacitor C and the switch SW12 makes a discharging circuit for the capacitor Cf. Since the time $t_1$ (shown at (d) in Fig. 7) required for the charging voltage to reach an input measured voltage is proportional to the latter, the flip-flop Q1 generates at its output a pulse signal having a frequency which is proportional to the voltage being measured. The pulse signal is counted by the counter 4, and when the count in the counter 4 reaches a predetermined value, the counter 4 produces a count-up output as shown at (f) in Fig. 7 to stop the counting operation in the timer 5 as illustrated at (g) in Fig. 7. The timer 5 has been counting clock pulses supplied from the pulse generator circuit 6 since the release of the reset signal PO3. As soon as counting is stopped, the count in the timer 5 is read via the terminal PI0—PI15 by the μ-COM processing circuit 7 which has been supplied with the count-up signal from the counter 4.

Assuming that the voltage applied to an input terminal + of the operational amplifier OP2 is Ea and the voltage applied to an input terminal—for charging the capacitor C is Eb, the voltages Ea, Eb can be expressed by the following equations:

$$Ea = K1K2VDD$$

$$Eb = \frac{1}{C}\int Idt = \frac{I}{C}t$$

where I is the constant current supplied to the capacitor C, and K1, K2 are constants as described above. If a time at which Ea=Eb is $t_1$, then

$$\frac{1}{C} \cdot t_1 = K1K2VDD$$

and hence the time $t_1$ can be determined by:

$$t_1 = \frac{C}{I}K1K2VDD \qquad (5)$$

With the capacitor C dischargeable with the time $t_c$ determined by the capacitor Cf and the resistor Rf, the charging and discharging time $T_1$ for the capacitor C can be measured by counting clock pulses from the reference clock generator circuit 6 before the capacitor C is charged and discharged n times. (To be more precise, only the charging time is measured). As charging ($t_1$) is effected n times and discharging ($t_c$) is effected (n−1) times as shown (d) in Fig. 7, the charging and discharging time $T_1$ can be determined by the following equation:

$$T_1 = nt_1 + (n-1)t_c \qquad (6)$$

Counting the capacitor chargings for n times results in increased resolution of the time measuring counters CT2, CT3, and the number n may be selected depending on the output frequency of the reference clock generator circuit 6 or the capacitance of the capacitor C.

After the charging and discharging time $T_1$ for the capacitor C has been determined, the μ-COM processing circuit 7 moves the switch SW2 with the mode selection signals PO1, PO2 to the $E_1$ measurement mode and the measures a charging and discharging time $T_2$ for the capacitor C in the foregoing manner. The mode of operation for $E_1$ measurement is entirely the same as mentioned above, with its time chart being shown at $E_1$ measurement mode on the right-hand side of Fig. 7. Since a measured voltage $E_1$ is applied to the input terminal $E_a$ of the operational amplifier OP2, a charging time $t_2$ for the capacitor C can be given as in equation (5) by:

$$t_2 = \frac{C}{I} K1(K2Vdd + E_1) \qquad (7)$$

The charging and discharging time $T_2$ for the capacitor C can be expressed as in equation (6) by:

$$T_2 = nt_2 + (n-1)t_c \qquad (8)$$

The difference between the times $T_2$, $T_1$ as expressed by the equations (8), (6) is given by:

$$T_2 - T_1 = n\frac{C}{I} K1E_1 = KE_1 \qquad (9)$$

The measured input voltage can thus be derived from the difference between the charging and discharging times $T_2$, $T_1$ for the capacitor C in the $E_1$ measurement mode and the zero measurement mode. The μ-COM processing circuit 7 effects an arithmetic operation to determine such a time difference, and carries out a predetermined conversion to measure the voltage or physical quantity.

With the foregoing arrangement, a change in a physical quantity is converted to a voltage change for measurement, and such a voltage change is in turn converted to a frequency signal. The frequency signal is then converted into a corresponding digital signal, on which predetermined arithmetic operations are effected to measure the physical quantity. The measurement apparatus is therefore advantageous in that it can measure physical quantities with increased accuracy, and can easily perform a variety of compensational arithmetic operations such as for zero point and spanning adjustment, temperature compensation and the like simply by changing programs for the μ-COM processing circuit 7.

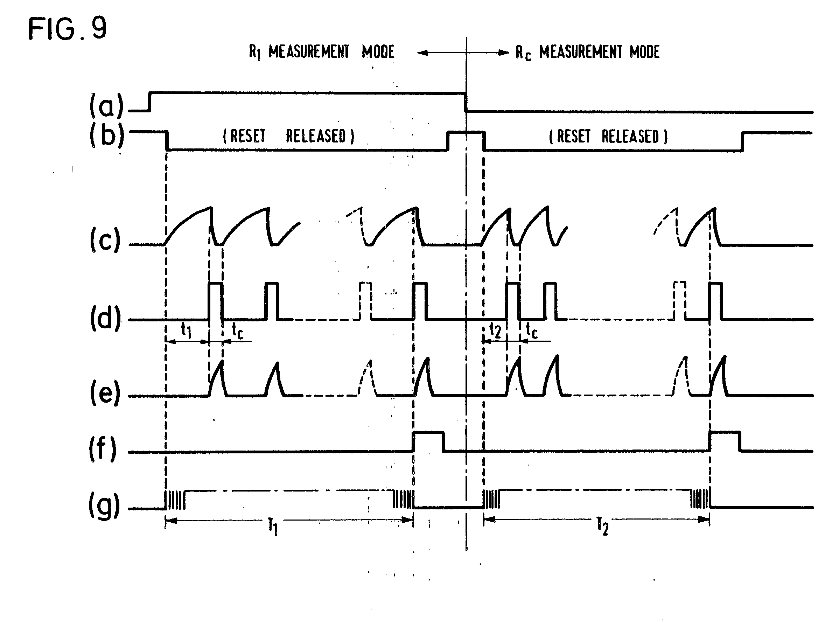

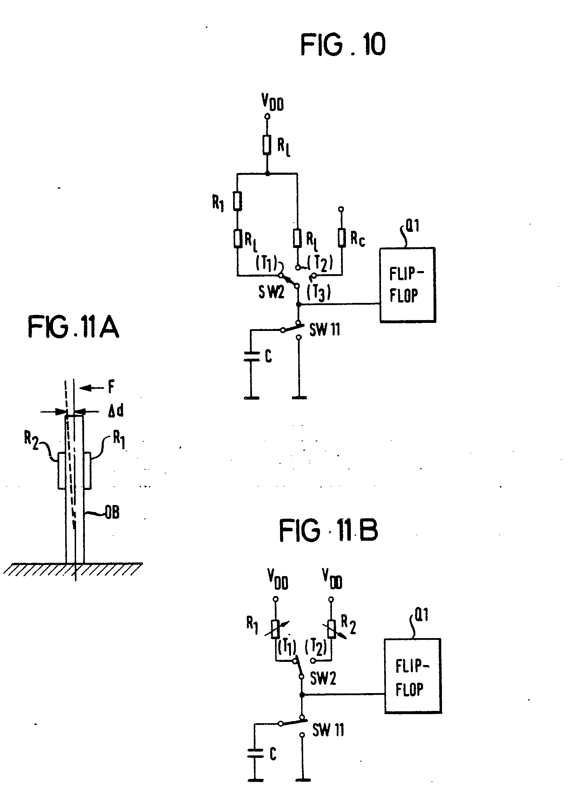

A measurement apparatus according to still another embodiment of the invention is suitable for use in applications in which a physical quantity is first detected as a resistance (electrical resistance) signal with a magnitude corresponding to the physical quantity. The measurement apparatus will be described with reference to the block diagram of Fig. 5 (the voltage detector 1 in Fig. 5 is replaced by a resistance detector 1), a circuit diagram of Fig. 8, and a waveform diagram of Fig. 9. A modified measurement apparatus will then be described with reference to Figs. 10 and 11.

As shown in Fig. 8, a detector 1 is composed of a measurement resistor $R_1$ and a standard resistor $R_c$. A detector selector circuit 2 comprises a switch SW2 (such as a relay or CMOS analog switch for example) for selecting either resistor $R_1$ or resistor $R_c$. A frequency converter circuit 3 is connected in series with the resistor $R_1$ or resistor $R_c$ and includes a switch SW1 (SW11, SW12) for selectively charging or discharging a capacitor C with a current dependent on the resistance of the

resistor $R_1$ or $R_c$, (the capacitor is charged in the illustrated embodiment) and for clearing or resetting a D-type flip-flop Q1. The flip-flop Q1 can be set when the charging voltage for the capacitor C exceeds a predetermined voltage level (threshold level), and reset after expiration of a predetermined period of time which is determined by a time constant (the product of resistance Rf and capacitance Cf). The μ-COM processing circuit 7 delivers mode selection signals PO1, PO2 to the switch SW2 in the selector circuit 2 to select the resistor $R_1$ measurement mode ($R_1$ mode) or the resistor $R_c$ measurement mode ($R_c$ mode).

The measurement apparatus operates as follows: With reference to Figs. 8 and 9, under an initial condition, no mode selection signal PO1, PO2 is given by the μ-COM processing circuit 7. The counter 4 (CT1) and the timer 5 remain reset by the reset signal PO3. When a resistor $R_1$ measurement mode signal as shown at (a) in Fig. 9 is supplied to release the reset signal PO3 as shown at (b) in Fig. 9, a path is formed from the power supply VDD to the resistor $R_1$, to the switch SW2, to the switch SW11 and to the capacitor C, whereupon the capacitor C is charged in the pattern illustrated at (c) in Fig. 9. When charging voltage for the capacitor C exceeds a threshold voltage VTH for the flip-flop Q1 after a period of time $t_1$, the flip-flop Q1 is set and produces an output via its output terminal Q. The output from the flip-flop Q1 is fed to the counter 4 and the switch SW1. As a result, the switch SW12 is opened to complete a charging circuit composed of the resistor Rf and the capacitor Cf. At this time, the switch SW11 is moved to discharge the capacitor C. When the charging voltage for the capacitor C reaches a predetermined level after a predetermined period of time $t_c$ as shown at (e) in Fig. 9, the flip-flop Q1 is cleared and produces an output pulse with a width $t_c$ as illustrated at (d) in Fig. 9. Upon resetting the flip-flop Q1, the switch SW1 is also turned off, and the switch SW12 is returned to the position shown in Fig. 8, whereupon a discharging circuit for the capacitor Cf is closed. Since the period of time $t_1$ is in proportion to the capacitance of the capacitor C and the resistance of the resistor $R_1$, the flip-flop Q1 produces via its output a pulse signal with a frequency which is proportional to the resistance of the resistor $R_1$. The pulse signal from the flip-flop Q1 is counted by the counter 4. When the count in counter 4 reaches a predetermined value, the counter 4 produces a count-up output as shown at (f) in Fig. 9 to de-energize the timer 5 to stop it from counting as shown at (g) in Fig. 9. The timer 5 has been counting clock pulses supplied from the pulse generator circuit 6 since the release of the reset signal PO3. The count in the timer 5 is read via the terminals PI0—PI15 by the μ-COM processing circuit 7 which has been supplied with the count-up signal from the counter 4.

The threshold voltage VTH for the flip-flop Q1 is given as follows:

$$VTH = VDD \left(1 - e^{-\frac{t_1}{R_1C}}\right)$$

The charging time $t_1$ (as shown at (d) in Fig. 9) for the capacitor C is expressed by:

$$t_1 = -R_1C \; \log_e \left(1 - \frac{VTH}{VDD}\right)$$

where VDD is the power supply voltage.

The time period $t_c$ can be determined by the following equation:

$$t_c = -RfCf \; \log_e\left(1 - \frac{VTH}{VDD}\right)$$

With the resistance of the resistor Rf and the capacitance of the capacitor Cf known, the timer period $t_c$ is constant.

Accordingly, by counting clock pulses supplied from the reference clock generator circuit 6 before charging and discharging the capacitor C $n$ times, the charging and discharging time $T_1$ for the capacitor C can be measured based on the output from timer 5 (more precisely, only the charging time is measured). As can be seen from (d) of Fig. 9, charging $(t_1)$ is effected $n$ times, and discharging $(t_c)$ is effected $(n-1)$ times, so that $T_1$ can be given by:

$$T_1 = nt_1 + (n-1)t_c \qquad (10)$$

By counting the capacitor chargings $n$ times, the resolution of the time measuring counter (CT2, CT3) is increased. The number $n$ may be selected to depend on the output frequency of the reference clock generator circuit 6, the resistance of the resistor $R_1$, or the capacitance of the capacitor C. In the illustrated embodiment, $n$ is selected to be 256.

After the charging and discharging time $T_1$ for the capacitor C has been determined, the μ-COM processing circuit 7 produces the signal PO1 or PO2 to shift the switch SW2 for the resistor $R_c$ measurement mode, so that a charging and discharging time $T_2$ for the capacitor C can be measured in a similar manner. The mode of operation for $R_c$ measurement is entirely the same as described above. A charging time $t_2$ can be expressed by the following equation:

$$t_2 = -R_cC \; \log_e\left(1 - \frac{VTH}{VDD}\right)$$

The charging and discharging time $T_2$ can be given by:

$$T_2 = nt_2 + (n-1)t_c \qquad (11)$$

The μ-COM arithmetic circuit 7 effects the following arithmetic operations based on the above equations (10), (11):

$$T_1 - (n-1)t_c = -nCR_1 \; \log_e\left(1 - \frac{VTH}{VDD}\right)$$

$$T_2 - (n-1)t_c = -nCR_c \; \log_e\left(1 - \frac{VTH}{VDD}\right)$$

Therefore, the following equation can be used to determine

$$\frac{T_1-(n-1)t_c}{t_2-(n-1)t_c} = \frac{R_1}{R_c} \qquad (12)$$

an unknown resistance $R_1$. The arithmetic operation according to equation (12) is effected to divide variations in the capacitance of the capacitor C, the power supply voltage VDD, or the threshold voltage VTH to thereby remove any influences that the above variations have. Where the switches SW1, SW2 comprise CMOS analog switches, they may pose a problem, since they present resistance when turned on. To avoid this problem, the switches SW1, SW2 may be designed as relay contacts.

The foregoing arrangement is applicable to uses in which line resistance is negligible. Where the line resistance Rl is not negligible, the following arrangement should be employed:

Fig. 10 shows a circuit arrangement for the detector to be used in applications in which the line resistance has an adverse effect on operation of the measurement apparatus. The arrangement of Fig. 10 is different from that shown in Fig. 8 in that there is included a circuit for measuring the line resistance Rl. The capacitor C, the switch SW11, and the flip-flop Q1 are of the same construction as that shown in Fig. 8.

In Fig. 10, a switch SW2 is moved successively to determine charging and discharging times for the capacitor C which differ with resistances $R_1+2Rl$, $2Rl$, and $R_c$. Assuming that charging times with the resistances $R_1+2Rl$, $2Rl$, and $R_c$ are $t_1$, $t_2$ and $t_3$, respectively, and charging and discharging times with the above resistances are $T_1$, $T_2$ and $T_3$, respectively, these times can be expressed as follows:

$$t_1 = -C(R_1+2Rl) \; \log_e\left(1 - \frac{VTH}{VDD}\right)$$

$$t_2 = -2CRl \; \log_e\left(1 - \frac{VTH}{VDD}\right)$$

$$t_3 = -CR_c \; \log_e\left(1 - \frac{VTH}{VDD}\right)$$

$$T_1 = nt_1 + (n-1)t_c$$

$$T_2 = nt_2 + (n-1)t_c$$

$$T_3 = nt_3 + (n-1)t_c$$

The following equation results from the above equations:

$$\frac{T_1 - T_2}{T_3 - (n-1)t_c} = \frac{R_1}{R_c} \qquad (13)$$

The μ-COM processing circuit 7 implements the arithmetic operation expressed by equation (13) to measure the resistance $R_1$.

An application in which pressure or strain is measured utilizing a change in resistance will now be described.

Fig. 11A shows a pair of wire strain gauges $R_1$, $R_2$ attached to both sides of an object OB for measuring a pressure F or a displacement $\Delta d$ imposed on the object OB.

When the object OB is displaced $\Delta d$ under a force F applied thereto, the resistance R of the wire strain gauges $R_1$, $R_2$ changes by $\Delta R$ which is substantially proportional to the force F or the displacement $\Delta d$. Fig. 11B illustrates a circuit arrangement for measuring the resistances $R_1$, $R_2$. The mode of operation of the arrangement of Fig. 11B is the same as that of the arrangement shown in Fig. 8. More specifically, the switch SW2 is shifted to select either the resistor $R_1$ or $R_2$ for determining the charging times $t_1$, $t_2$ and the charging and discharging times $T_1$, $T_2$ for the resistors $R_1$, $R_2$, respectively, and the following arithmetic operation is implemented:

$$\frac{T_1 - T_2}{T_1 + T_2 - 2(n-1)t_c} = \frac{R_1 - R_2}{R_1 + R_2} \qquad (14)$$

Since $R_1 = R + \Delta R$, and $R_2 = R - \Delta R$ in Fig. 11A, the right-hand side of the equation (14) becomes $\Delta R/R$, and the pressure applied or the strain resulting therefrom can be derived from $\Delta R$.

With the foregoing arrangement of the present invention, a change in a physical quantity is converted into a resistance change, which is then converted into a corresponding frequency signal. The frequency signal is thereafter converted into a digital signal, on which predetermined arithmetic operations are effected to measure the physical quantity. The measurement apparatus can measure physical quantities with increased accuracy, and can perform various compensational arithmetic operations such as zero point and spanning adjustment and temperature compensation simply by changing programs for the μ-COM processing circuit 7.

While in the illustrated embodiment the physical quantity is measured by measuring the charging time for the standard capacitor C, the physical quantity can be determined by measuring the discharging time for the capacitor C in the same manner. Although the capacitor C and the flip-flop Q1 have been described as being shared by both the $R_1$ and $R_c$ measurement modes, separate capacitors and flip-flops may be provided for the $R_1$ and $R_c$ measurement modes.

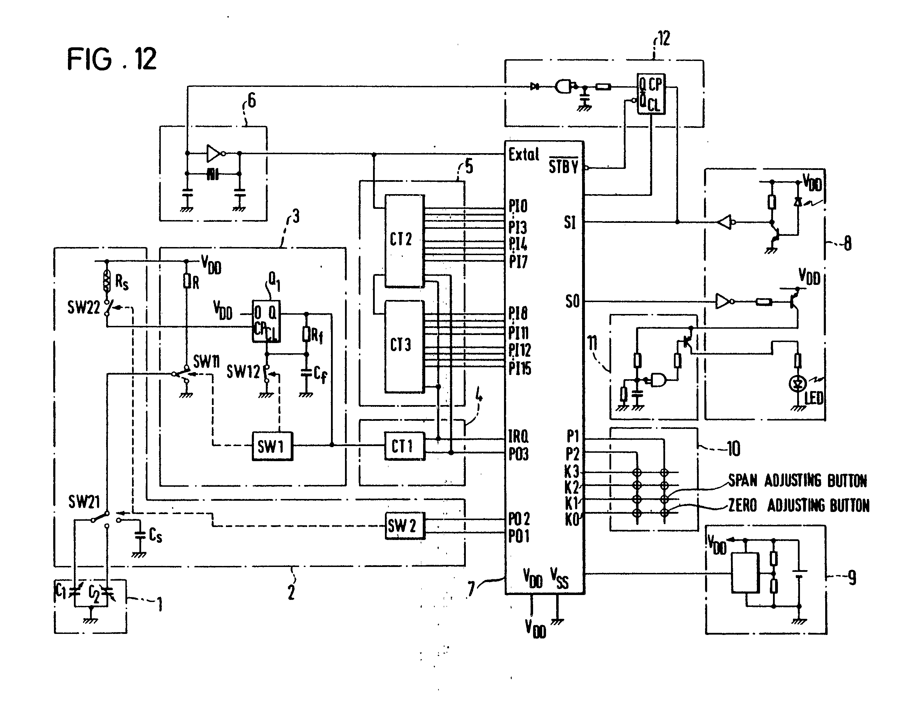

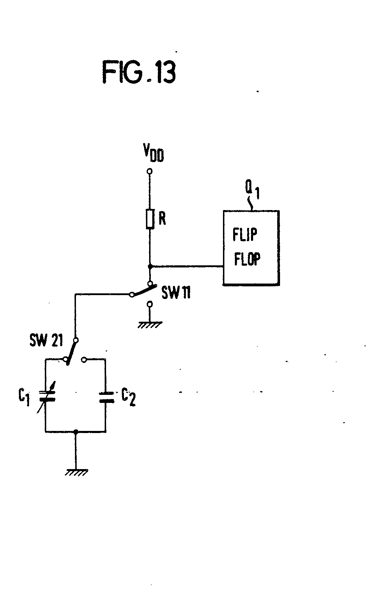

According to still another embodiment, a measurement apparatus first detects a physical quantity as a capacitance (electrostatic capacity) signal with a magnitude which corresponds to the physical quantity. The measurement apparatus will now be described with reference to the block diagram of Fig. 5 (the voltage detector 1 in Fig. 4 is replaced with a capacitance detector 1), a circuit diagram of Fig. 12, and the wavefrom diagram of Fig. 9 (which is shared by the circuits shown in Figs. 8 and 12). A modification will also be described with reference to Fig. 13.

As shown Fig. 12, a detector 1 comprises capacitors $C_1$, $C_2$ and a detector selector circuit 2 comprises a CMOS analog switch SW2 (SW21, SW22) for selecting the capacitor $C_1$, $C_2$, a temperature measuring capacitor Cs, or a thermistor Rs. A capacitance-to-frequency converter circuit 3 is composed of an analog switch SW1 (SW11, SW12) for effecting charging and discharging of the capacitors $C_1$, $C_2$ and for clearing or resetting a D-type flip-flop Q1. The flip-flop Q1 can be set when the charging voltage for the capacitor $C_1$ or $C_2$ exceeds a predetermined voltage level (threshold level), and reset after expiration of a predetermined interval of time determined by a time constant (determined in turn by a resistance Rf and a capacitance Cf). The μ-COM processing circuit 7 supplies mode selection signals PO1, PO2 to the analog switch SW2 in the selector circuit 2 for selecting a capacitance $C_1$ measurement mode, a capacitance $C_2$ measurement mode, or a temperature measurement mode (measurement using the resistor Rs and the capacitor Cs).

The circuits shown in Figs. 8 and 12 differ from one another only in that the circuit in Fig. 8 relies on a proportional relationship between Rf of the time constant RfCf and the physical quantity to be measured, whereas the circuit in Fig. 12 relies on a proportional relationship between Cf of the time constant RfCf and the physical quantity to be measured. The measuring operation of the circuit illustrated in Fig. 12 can thus be understood when reference is made to the foregoing description relating to the operation of the circuit illustrated in Fig. 8.

After the charging and discharging time $T_1$ for the capacitor $C_1$ has been determined, the μ-COM processing circuit 7 produces the signal PO1 or PO2 to shift the switch SW21 for the capacitance $C_2$ measurement mode in which to measure a charging and discharging time $T_2$ for the capacitor $C_2$. The charging and discharging times $T_1$, $T_2$ can be expressed as in equations (10), (11) by:

$$T_1 = nt_1 + (n-1)t_c$$

$$T_2 = nt_2 + (n-1)t_c$$

The μ-COM processing circuit 7 implements the following arithmetic operations based on the above equations:

$$T_1+T_2-2(n-1)t_c=-R(C_1+C_2)\ \log_e(1-\frac{VTH}{VDD})$$

$$T_1-T_2=-R(C_1-C_2)\ \log_e(1-\frac{VTH}{VDD})$$

$$\frac{T_1-T_2}{T_1+T_2-2(n+1)t_c}=\frac{C_1-C_2}{C_1+C_2} \qquad (15)$$

As can be understood from the description with reference to Fig. 2(a), the equation (15) is proportional to the displacement, so that the µ-COM processing circuit 7 can measure the displacement by implementing the foregoing arithmetic operations.

In the above circuit arrangement, the capacitances of the capacitors $C_1$, $C_2$ are varied differentially to measure a physical displacement such as a differential pressure $\Delta P$. However, the principles of the illustrated measurement apparatus can be applied to an arrangement such that one of the capacitors $C_2$ is fixed and the other capacitor $C_1$ is variable, as illustrated in Fig. 13. Such a modification can readily be understood in principle from Fig. 2(B). With the modified arrangement, a pressure P should be determined instead of the differential pressure $\Delta P$ according to the following equation:

$$P=\frac{C_1-C_2}{C_2}=\frac{T_1-T_2}{T_2-(n-1)t_c} \qquad (16)$$

Where a stray capacity $C_{ST}$ is connected in parallel to each of the capacitors $C_1$, $C_2$, $C_1$ becomes $C_1+C_{ST}$ and $C_2$ becomes $C_2+C_{ST}$. $C_1-C_2$ is not adversely affected by the stray capacitor $C_{ST}$. However, $2C_{ST}$ is added to $C_1+C_2$. To compensate for such inclusion of $2C_{ST}$, an arithmetic operation of

$$(C_1-C_2)/(C_1+C_2-2C_{ST})$$

should be performed, that is, the following equation should be used instead of equation (15) to substract a constant K:

$$\frac{T_1-T_2}{T_1+T_2-2(n-1)t_c-K} \qquad (17)$$

Likewise, instead of the equation (16), an arithmetic operation of

$$(C_1-C_2)/(C_2-C_{ST})$$

should be performed to determine the pressure P, that is, the following equation should be employed:

$$\frac{T_1-T_2}{T_2-(n-1)t_c-K} \qquad (18)$$

Temperature compensation will now be described. The µ-COM processing circuit 7 shifts the switch SW21 with the signals PO1, PO2 for the temperature measurement mode. A charging and discharging path from the capacitor Cs to switches SW21, SW11, SW22, and to the thermistor $R_S$ is closed as with the measurement mode for the capacitors $C_1$, $C_2$. Although the resistor R is connected in parallel with thermistor Rs, thermistor Rs and resistor R have a relationship of Rs≪R, so that operation will not be influenced by resistor R.

A charging time $t_3$ for capacitor Cs is given by:

$$t_3=-RsCs\ \log_e(1-\frac{VTH}{VDD})$$

A total charging and discharging time $T_3$ for capacitor Cs is expressed as follows:

$$T_3=nt_3+(n-1)t_c \qquad (19)$$

Temperatures can be measured by storing in advance a relationship between the charging and discharging time $T_3$ and temperatures in a memory (not shown) of the µ-COM processing circuit 7. Measurements tend to be affected directly by variations in the voltages VDD and VTH. However, the errors are caused in amounts in compensation only, and hence are negligible.

Conversion of capacitances into frequency signals is liable to cause errors due to variation in the time

$$t_c(=-RfCf\ \log_e(1-\frac{VTH}{VDD})).$$

Such errors can be rendered negligible by selecting the charging times $t_1$, $t_2$ such that $t_1 \gg t_c$, $t_2 \gg t_c$.

As is apparent from equations (15), (16), factors such as the resistance R and the voltages VDD, VTH are divided, since they serve as denominator and numerator, and hence variations in these factors are negligible.

While in the foregoing embodiment the charging time for the capacitor is measured to detect a displacement, its discharging time may be similarly measured to detect the displacement.

With the embodiment shown in Fig. 12, the resistor R and the flip-flop Q1 are shared by the detection of the capacitances of the capacitors $C_1$, $C_2$. However, separate resistors and flip-flops may be provided for respectively detecting the capacitances of the capacitors $C_1$, $C_2$.

According to the arrangement of the present invention, the measurement apparatus is composed of a digital circuit so as to be free from influences of noises and temperatures, and hence can measure physical quantities with increased accuracy. The apparatus consumes a relatively small amount of electric power. Since influences of temperatures and stray capacities can be compensated for by arithmetic operations, no special compensation circuits are necessary for this purpose. Pressures, instead of differential pressures, can be measured easily simply by changing arithmetic operations, that is, by selecting a suitable program. Thus, the measurement apparatus is of considerable practical advantage.

Processes of adjusting a zero point and spanning according to the present invention will be described with reference to Fig. 4.

The keyboard 10 includes push buttons PB for zero point and spanning adjustment, respectively. When the operator depresses the zero point adjustment push button PB after confirming that no input to be measured is applied, the µ-Cmm processing circuit 7 starts performing the above measuring operations under a command from push button PB. The result of measurement is then stored in the memory (not shown) of the µ-COM processing circuit 7. The foregoing procedure is then repeated after confirming that an input is applied 100%, and the result of arithmetic operations is also stored in the memory. These stored data will be used to compensate for the results of subsequent arithmetic operations. The memory in the µ-COM processing circuit 7 should preferably comprise a CMOS RAM random-access memory) backed up by a battery.

In the above arrangement, the measurement apparatus includes the digital arithmetic circuit and the memory for storing the results of arithmetic operations when the input to be measured is 0 and 100% in response to the operation of the push button. The storing procedures are free from mutual interference, so that there is no risk of the zero point being shifted during spanning adjustment. Accordingly, adjustment operation is easy and accurate.

One application in which optical information is transmitted between the measurement apparatus of the invention and an upper computer in a control room (not illustrated) will be described with reference to Fig. 4.

The optical transmission circuit 8 as illustrated in Figs. 4 and 5 serves to carry out optical transmission of information of the type described, and is constructed as shown in the block indicated by the reference numeral 8 in Fig. 4. The optical transmission circuit 8 is composed primarily of a photodiode PD for receiving optical signals transmitted from an upper processor or computer, and a light-emitting diode LED for transmitting optical signals to the upper processor. The measurement apparatus is caused to operate only at desired times in response to commands delivered as optical signals from the upper processor. Results of measurement are transmitted to the upper processor when the light-emitting diode LED in the optical transmission circuit 8 is energized. The optical transmission may be performed by a known pulse-width modulation (PWM) or pulse-code modulation (PCM) system, or otherwise simply by delivering optical signals with predetermined frequencies or wavelengths. Where a plurality of measurement apparatus are connected to the upper processor, information can be transmitted in a multiplex mode. Since the measurement apparatus operates only at required times, it may be powered by a battery power supply circuit 9 of relatively small capacity designed to supply electric power to various parts of the measurement apparatus. The battery power supply circuit 9 may comprise a lithium cell, an automatically chargeable combination of a solar cell and a nickel-cadmium battery, or a nickel-cadmium battery that can be put into operation when supplied with optical power.

With the above arrangement, the measurement apparatus is a digital circuit construction which is free from adverse effects caused by noises or temperatures. The measurement apparatus features increased measuring accuracy and a relatively small power requirement. Optical transmission of information between the measurement apparatus and the upper processor or computer is not adversely affected by noises or surges, resulting in a higher measuring accuracy. The measurement apparatus with the optical transmission system can be safely used in an explosive environment.

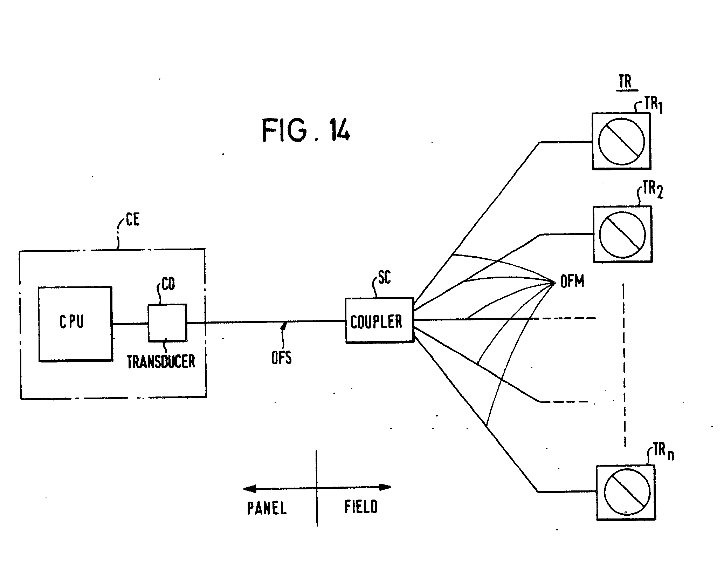

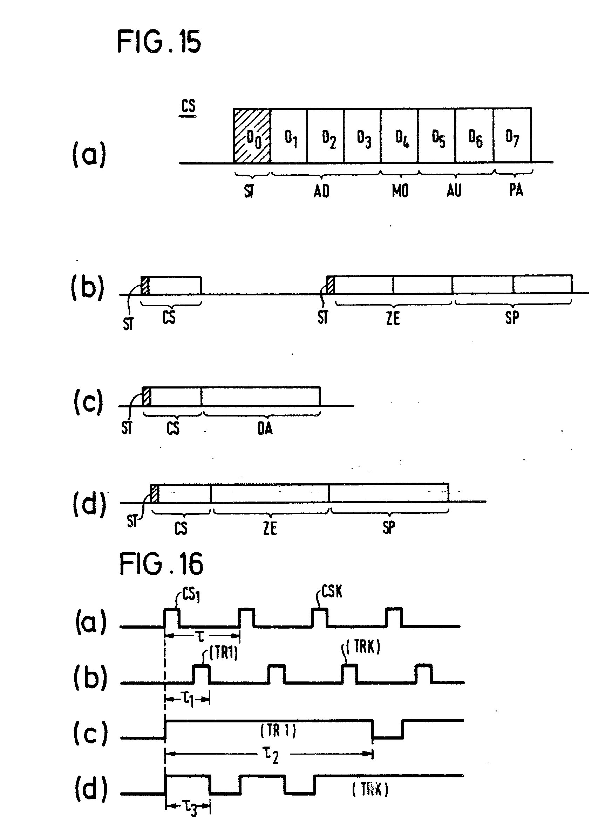

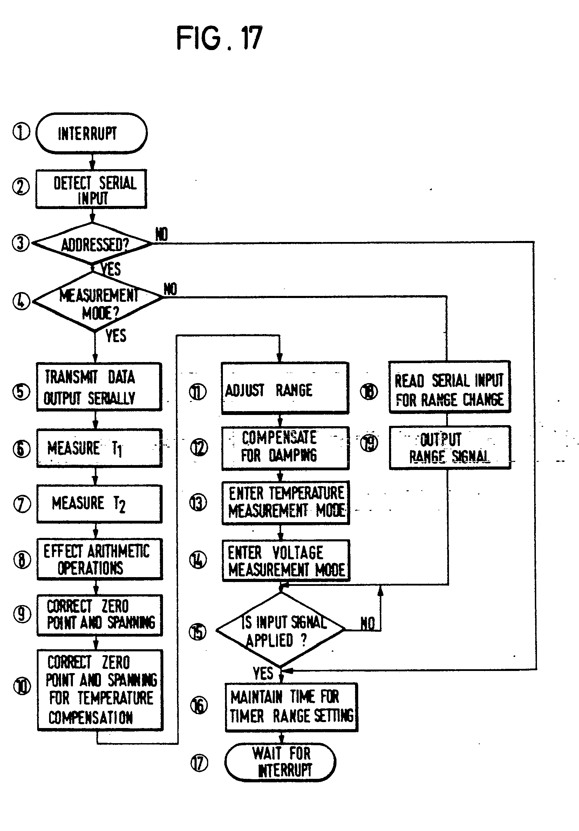

A system including a central processing unit and a plurality of measurement apparatus connected thereto will be described with reference to Fig. 14 which shows a system arrangement, Fig. 15 illustrative of forms of information transmitted between the central processing unit and the measurement apparatus, Fig. 16 which is a timing chart for information transmitting and receiving operations, and Fig. 17 which is a flow chart for measuring operations.

As shown in Fig. 14, the system includes a central control room CE having therein a central processing unit CPU and a transducer or transmitter unit CO including electric-to-optical and optical-to-electric transducers, a plurality of digital measurement apparatus $TR_1 - TR_n$ (hereinafter referred to as "transmitter) for measuring a variety of physical quantities, a star coupler (commercial name) for mixing and dividing optical information between the central processing unit CPU and the transmitters TR, and optical fibers OFS, OFM. The star coupler SC is located in the field for economical reasons so that the optical fibers OFM coupled to the transmitters TR will not be too long.

Fig. 15 shows forms of information delivered between the transmitters TR and the central processing unit CPU. Fig. 15(a) is illustrative of control information CS, Fig. 15(b) shows a form of information transmitted from the central processing unit CPU to the transmitters TR for setting a measurement range (a condition hereinafter referred to as a "range setting mode"), Fig. 15(c) illustrates a form of information delivered when measured data are transmitted from a transmitter TR to the central processing unit CPU (a condition called a "measurement mode"), and Fig. 15(d) shows a form of information sent back from a transmitter TR to the central processing unit CPU for confirming that the transmitter has received range setting information from the central processing unit CPU.

As illustrated in Fig. 15(a), the control information CS is composed of a start bit ST ($D_0$), address information AD ($D_1-D_3$) indicative of the identification number of each transmitter, mode information MO ($D_4$) indicative of the measurement mode or the range setting mode, auxiliary information AU ($D_5$, $D_6$), and a parity bit PA ($D_7$). During the measurement mode, the information as shown in Fig. 15(a) is delivered from the central processing unit CPU to the transmitters TR, and control information CS and measured data DA as shown in Fig. 15(c) are transmitted from an addressed transmitter TR to the central processing unit CPU. All of the transmitters TR are put into operation simultaneously in response to the start bit ST, and those transmitters TR which are not addressed will be de-energized after expiration of a predetermined time interval. In the range setting mode, the transmitters TR are supplied with the control information CS as illustrated in Fig. 15(b), and after expiration of a predetermined time period, with zero point information ZE including the start bit ST and spanning information SP, whereupon the transmitters TR deliver the received information as shown in Fig. 15(d) back to the central processing unit CPU to thereby inform the latter that they have properly received the range setting information.

Assuming that the transmitter TR1 is selected by control information CS1 and the transmitter TRK is selected by a control signal CSK when control information as shown in Fig. 16(a) is supplied from the central processing unit CPU, the transmitters TR1, TRK receive the information CS1, CSK after a predetermined period of time as illustrated in Fig. 16(b). The transmitter TR1 then operates as shown in Fig. 16(c). The transmitter TRK stops operating a predetermined period of time $\tau_3$ after the information CS1 has been supplied, and starts to operate in response to receiving the information CSK. Where an interval $\tau$ between adjacent pieces of information (as shown in Fig. 16(a)) is greater than a time $\tau_1$ required for the transmitter to receive information (as shown in Fig. 16(b)), and is also greater than a one-cycle period $\tau_2$ required to call the transmitter of the same address, that is, a period of time required for one transmitter to effect measurement and arithmetic operations, access time intervals for or the order of selection of the transmitters can be freely selected or changed for transmitting information.

Information transmitting and receiving operations of each transmitter will be described with reference to Fig. 17.

The μ-COM processor in the transmitter starts to operate in response to an interrupt signal (start signal) supplied from the upper computer CPU (①), reads an input signal (control information) as shown in Fig. 15 (②), and determines whether the transmitter is addressed or not by the received input signal (③). If it is not addressed, then a predetermined time is maintained (⑯) and the transmitter enters a mode for awaiting a next interrupt (⑰), so that the transmitter will not operate in error in response to range setting information for another transmitter. If the transmitter is addressed, the μ-COM processor therein determines if the measurement mode is selected or not (④). If not, then the μ-COM processor reads input data for changing the range (⑱), delivers the input data back to the upper computer CPU to confirm that the input data has been received (⑲), confirms that there is another input signal (⑮) to prevent erroneous operation due to another such input signal thereafter maintains a predetermined period of time (⑯), and enters into an interrupt awaiting mode (⑰). If the measurement mode is selected at step (④), the result of previous arithmetic operations is then transmitted serially (⑤), the charging and discharging time $T_1$ is measured (⑥) to effect predetermined arithmetic operations, time $T_2$ is also measured if necessary (⑦), and necessary arithmetic operations are performed on the basis of the data of the above measurements (⑧). Compensation for a zero point and spanning is then effected (⑨), and similarly, compensation for a zero point and spanning due to temperatures is carried out (⑩). Thereafter, the μ-COM processor adjusts the range (⑪) based on the range setting information which has already been received from the central processing unit CPU on the panel. If there is any damping, a predetermined arithmetic operation is performed to compensate for such damping (⑫). Then, the temperature is measured (⑬), the battery voltage is measured (⑭), another input signal is confirmed (⑮) to prevent the transmitter from malfunctioning due to such another input signal. Subsequently, a predetermined period of time is inserted (⑯), and the transmitter enters the interrupt awaiting mode (⑰).

In the foregoing arrangement of the present invention, the measurement apparatus is a circuit arrangement capable of digital processing for increased measuring accuracy. With the measurement apparatus or transmitters coupled to an upper processor through optical transmission paths, information on measured data or other data can be transmitted quite reliably over the optical transmission paths without being adversely affected by noises or surges. Since the transmitters are optically coupled to the upper processor by the star coupler, the number and length of optical transmission paths can be reduced, resulting in an economical advantage. The system of the present invention is also advantageous in that the failure of one transmitter does not adversely affect other transmitters while in operation, an advantage over systems in which transmitters are continuously coupled with each other.

By suitably changing forms of information to be delivered from the central processing unit CPU to the transmitters, setting of measurement ranges or damping, or adjustment of a zero pointing and spanning can be performed under the control of the central processing unit CPU.

The manner in which the clock generator circuit 6 and the μ-COM processing circuit 7 are intermittently energized in the measurement apparatus of the invention will be described with reference to Fig. 4 and Figs. 18, 19 which are timing charts for signals.

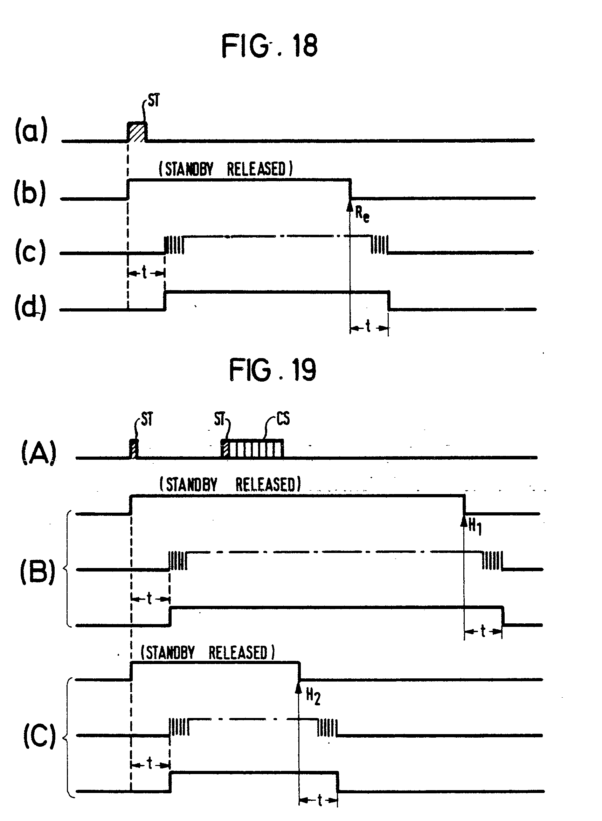

The measurement apparatus performs predetermined operations under the command from the central processing unit installed in the central control room. Such a command is received by the photodiode PD in the optical transmission circuit 8. When the command (as shown by the signal ST in Fig. 18(a) is received by the photodiode PD, a transistor TR is switched to become conductive, supplying a signal at a low logic level to an inverter IN. The inverter IN applies an inverted signal to an input terminal SI of the μ-COM processing circuit 7 and a terminal CP of a flip-flop FF in the standby mode circuit 12. The flip-flop FF is then set, and the μ-COM processing circuit 7 is released from the standby condition as illustrated in Fig. 18(b). An output from a terminal Q of the flip-flop FF as it is set is delayed for a predetermined period of time (as shown by t in Fig. 18(c)) by a delay circuit comprising a resistor $R_{SB}$ and capacitor $C_{SB}$. The clock generator circuit 6 starts to operate after expiration of such a period of time t as shown in Fig. 18(c). When the clock generator circuit 6 starts operating, the μ-COM processing circuit 7 also starts operating as shown in Fig. 18(d) to perform predetermined arithmetic operations under the command from the central processing unit. When the arithmetic operations have been completed, the μ-COM processing circuit 7 resets the flip-flop FF via a terminal PO4 (as shown by the arrow Re in Fig. 18). The μ-COM processing circuit 7 enters a standby mode in response to the reception of a reset signal from a terminal Q̄ of the flip-flop FF. With the delay circuit interposed between the flip-flop FF and the clock generator circuit 6, the clock generator circuit 6 and the μ-COM processing circuit 7 do not stop their operation immediately, but are delayed for an interval t before they are inactivated. In other words, the μ-COM processing circuit 7 is de-energized after it has completed its arithmetic operations and the interval t has been inserted in which the μ-COM processing circuit 7 enters the standby mode.

The above process deals with intermittent operation of the single measurement apparatus connected to the central processing unit. The manner in which a plurality of measurement apparatus connected to the central processing unit are driven intermittently in parallel with one another will be described with reference to Fig. 19. The plurality of measurement apparatus are simultaneously started by start information (as shown by a signal ST in Fig. 19(A)), supplied from the central processing unit CPU, whereupon the μ-COM processing circuits in the measurement apparatus are released from a standby condition, and the clock generator circuits therein start operating after expiration of a predetermined delay time. Some measurement apparatus are addressed as shown in Fig. 19(B) and the other measurement apparatus are not addressed as illustrated in Fig. 19(C). The addressed measurement apparatus enter a standby condition after they have performed predetermined arithmetic operations as shown by arrow H1. The measurement apparatus that are not addressed, on the other hand, are shifted to a standby condition after expiration of a predetermined interval of time as indicated by arrow H2 in Fig. 19(C). At any rate, the measurement apparatus are controlled by their own μ-COM processing circuits so as not to effect an undesired operation, thus reducing electric power consumption.

In the above construction of the invention, the clock generator circuit and the digital arithmetic circuit in the measurement apparatus which are powered by a battery and consume relatively much electric power, are energized only as required. The measurement apparatus can, therefore, be battery-powered and largely reduces its power consumption.

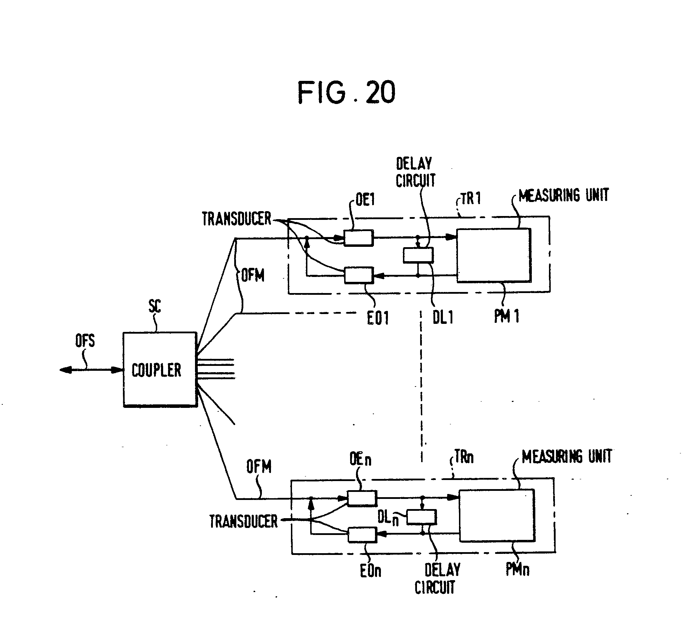

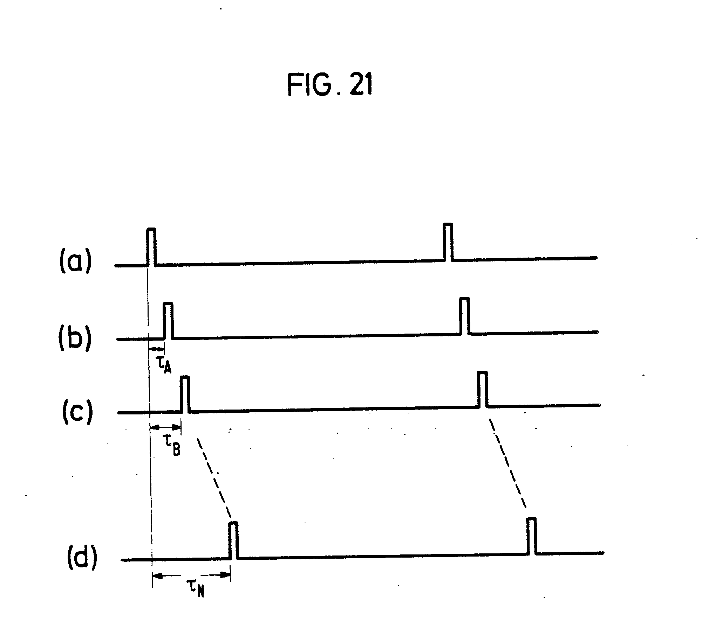

A system in which optical parts in an optical transmission circuit can be traced for failure or malfunction will be described with reference to a block diagram of Fig. 20 and a timing chart of Fig. 21.

The system illustrated in Fig. 20 includes a star coupler SC (commercial name); optical fibers OFS, OFM and a plurality of measurement apparatus or transmitters TR1—TRn. The measurement apparatus TR1—TRn include electric-to-optical transducers EO1—EOn, optical-to-electric transducers OE1—OEn, delay circuits DL1—DLn such as shift registers, monostable multivibrators, or timers for detecting parts failures, and measuring units PM1—PMn for measuring physical quantities, all respectively. The transducers OE1—OEn, EO1—EOn, and delay circuits DL1—DLn constitute transmitting units, respectively.

In operation, a control signal is delivered from an upper computer (not shown) via the star coupler SC to the measurement apparatus, in which the control signal is received by the optical-to-electric transducers OE1—OEn as shown by Fig. 21(a). The delay circuits DL1—DLn are designed to delay signals for mutually different delay times. Thus, the control signal is delayed for different times $\tau_A$, $\tau_B$, ... $\tau_N$ by the delay circuits, respectively, as shown in Figs. 21(b) through 21(d), and delayed signals are fed to the electric-to-optical transducers EO1—EOn, respectively, from which the signals are sent back to the upper computer via the star coupler SC. The upper computer can ascertain the measurement apparatus from which the control signal emanates by monitoring the time intervals required for the control signal to be transmitted and sent back. The foregoing operation is performed irrespective of the operation of the μ-COM processing circuits in the measurement apparatus, and hence should not burden the μ-COM processing circuits in operation.

With such an arrangement, the failures of optical parts at least in the measurement apparatus can be detected by simple means added to delay a control signal from an upper computer for predetermined periods of time. Thus, positions at which optical parts have failed can be traced, and measures can easily be taken against malfunctions which would otherwise be caused by the parts failures.

An arrangement for detecting accidental continued energization of the light-emitting element in the optical transmission circuit will be described with reference to Fig. 4.

The optical transmission circuit 8 includes a transistor TRA in addition to the light-emitting diode LED. The accidental LED energization detector circuit 11 comprises a charging circuit composed of a resistor RL and a capacitor CL, a gate G, and a transistor TRB. Under normal conditions, the transistors TRA, TRB are energized by a pulse supplied from an output terminal SO of the μ-COM processing circuit 7, completing a circuit for energizing the light-emitting diode LED. If the output from the terminal SO of the μ-COM processing circuit 7 is continuously delivered for some reason, a potential at the point Po gradually increases. When the potential reaches a predetermined level after a predetermined period of time, the voltage is applied via the gate G to the transistor TRB, which is then turned off. Thus, the circuit for energizing the light-emitting diode LED is broken to thereby de-energize the light-emitting diode LED. The potential at the point Po reaches the predetermined level after the certain period of time which is determined by a time constant dependent on the resistor RL and the capacitor CL. Therefore, continued energization of the light-emitting diode LED beyond the predetermined period of time can be detected, and the continuously energized light-emitting diode LED then be de-energized. The above detecting operation has no bearing on the operation of the μ-COM processing circuit, which should therefore not be burdened by such detecting operation.

With the foregoing arrangement of the present invention, there is provided a means for integrating a current that flows through the light-emitting element for converting m.asured data into an optical signal and for transmitting the latter. When the current as integrated by the means reaches a predetermined level, the light-emitting element is de-energized. Thus, serious troubles in optical transmission can be avoided by such a simple arrangement, and the measurement apparatus can operate highly reliably.

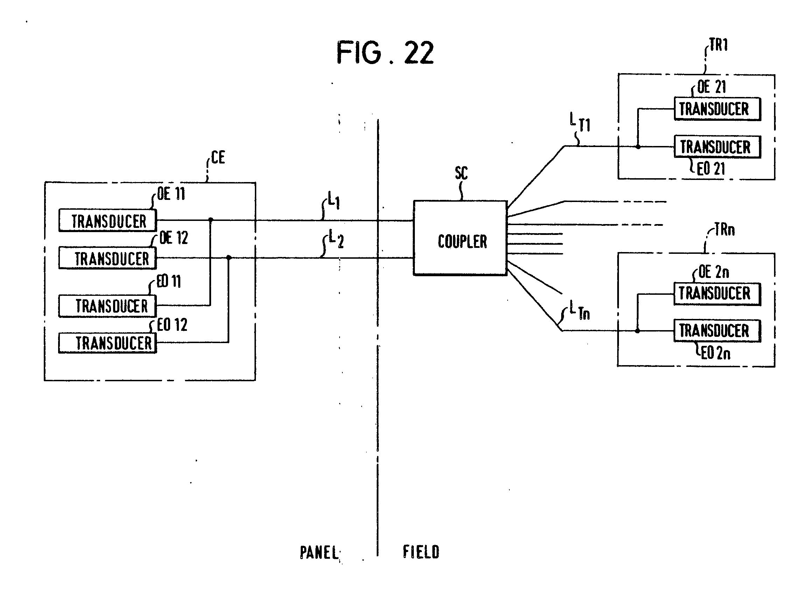

Fig. 22 is a block diagram of a system according to still another embodiment in which any trouble in the central processing unit, the light-emitting and light-receiving elements in the measurement apparatus, or the transmission paths can be detected positionally.

As shown in Fig. 22, the system comprises light-receiving elements OE11, OE12, OE21—OE2n such as photodiodes (PD), light-emitting elements EO11, EO12, EO21—EO2n such as light-emitting diodes (LED), a central control room or panel CE, a star coupler SC by which two optical transmission paths $L_1$, $L_2$ are coupled for optical transmission with a plurality of n optical transmission paths $L_{T1}$—$L_{Tn}$, and a plurality of measurement apparatus or transmitters $TR_1$—$TR_n$ installed in the field.

The measurement apparatus or transmitters $TR_1$—$TR_n$ are coupled by the star coupler SC to the optical transmission paths $L_1$, $L_2$ for dividing optical information at the ratio of 2:n or mixing optical information at the ratio of n:2, the optical transmission paths $L_1$, $L_2$ being coupled to a central processing unit in the central control room CE. Thus, the optical transmission paths $L_1$, $L_2$ have a double construction, and the central processing unit in the central control room CE, accordingly has two pairs of light-emitting elements EO11, EO12 and light-receiving elements OE11, OE12.

The operation for detecting a position of failure will be described with reference to Fig. 22.

One of the light-emitting elements EO11, EO12 in the central control room CE is selected to transmit desired information. The information is supplied over one of the optical transmission paths $L_1$, $L_2$ to the star coupler SC where the information is divided into n pieces. The n pieces of information are delivered respectively over the optical transmission paths $L_{T1}$—$L_{Tn}$ and received respectively by the light-receiving elements OE21—OE2n in the transmitters. In response to the received information, the transmitters send back certain information via the light-emitting elements EO21—EO2n to the central control room CE. Thus, the central processing unit in the central control room CE can locate a failure, if any, by determining whether the information based on the transmitted command information has been sent back or by checking the content of the received information.

It is now assumed that the light-receiving element OE11 in the central processing unit has failed and no other failure has occurred. When command information is transmitted out of the light-emitting element EO11, responsive information is sent back from the transmitters $TR_1$—$TR_n$ via the star coupler SC to the optical transmission paths $L_1$, $L_2$. The light-receiving element OE12 receives the returned information, although the light-receiving element OE11 cannot receive the returned information because of its failure. When the light-emitting element EO12 is selected to transmit command information, no returned information can be received by the light-receiving element OE11 for the same reason either. Where the light-emitting element EO11 has

failed and is selected to deliver command information, no returned information can be received by either of the light-receiving elements OE11, OE12. When the light-emitting element EO11 fails, the light-receiving elements OE11, OE12 can receive such returned information only when the light-emitting element EO12 is selected to transmit command information. Where the optical transmission path $L_1$ has failed, no information can be received by the light-receiving elements OE11, OE12 when command information is transmitted by the light-emitting

element EO11, but information can be received by the light-receiving element OE12 when the light-emitting element EO12 is selected to produce command information. The positions of failure (a), and reception ($\bigcirc$) and non-reception (X) of returned information by the light-receiving elements OE11, OE12 are tabulated in the following table ((b) which indicates selection of the light-emitting element EO11 for the transmission of command information, and (c) indicates selection of the light-emitting element EO12 for transmitting command information):

| (a) Failure position | (b) EO11 selected | | (c) EO12 selected | |
|---|---|---|---|---|
| | OE11 | OE12 | OE11 | OE12 |
| OE11 | X | $\bigcirc$ | X | $\bigcirc$ |
| OE12 | $\bigcirc$ | X | $\bigcirc$ | X |
| EO11 | X | X | $\bigcirc$ | $\bigcirc$ |
| EO12 | $\bigcirc$ | $\bigcirc$ | X | X |
| $L_1$ | X | X | X | $\bigcirc$ |
| $L_2$ | $\bigcirc$ | X | X | X |
| SC | X | X | X | X |
| $L_{T1}$—$L_{Tn}$ OE21—2n EO21—2n | The contents of returned information are checked. | | | |

A study of the above table indicates that the way in which the light-receiving elements OE11, OE12 receive information varies with the positions of failure, and hence the central processing unit in the central control room can locate failures by inspecting the pattern of the table. It is impossible to locate failure positions in the transmission paths $L_{T1}$—$L_{Tn}$ and the elements OE21—2n, EO21—2n in the transmitters $TR_1$—$TR_n$. However, failures can be located in transmitter systems including optical transmission paths and light-emitting and light-receiving elements by checking the contents of returned information.

In the arrangement as described above, the optical transmission paths are of a double circuit construction, and two pairs of light-emitting and light-receiving elements are provided in the central processing unit in the central control room for the double optical transmission paths. The entire system, therefore, has increased operation reliability, and failures can be located with ease.

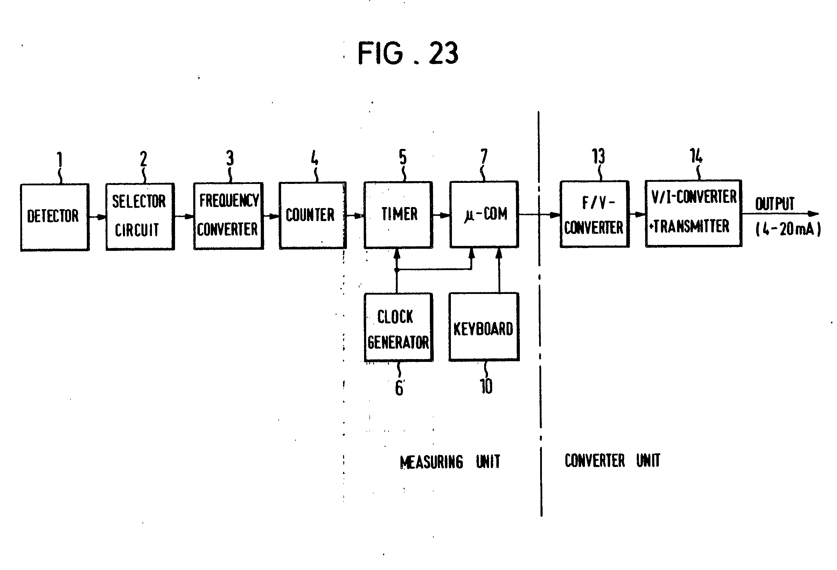

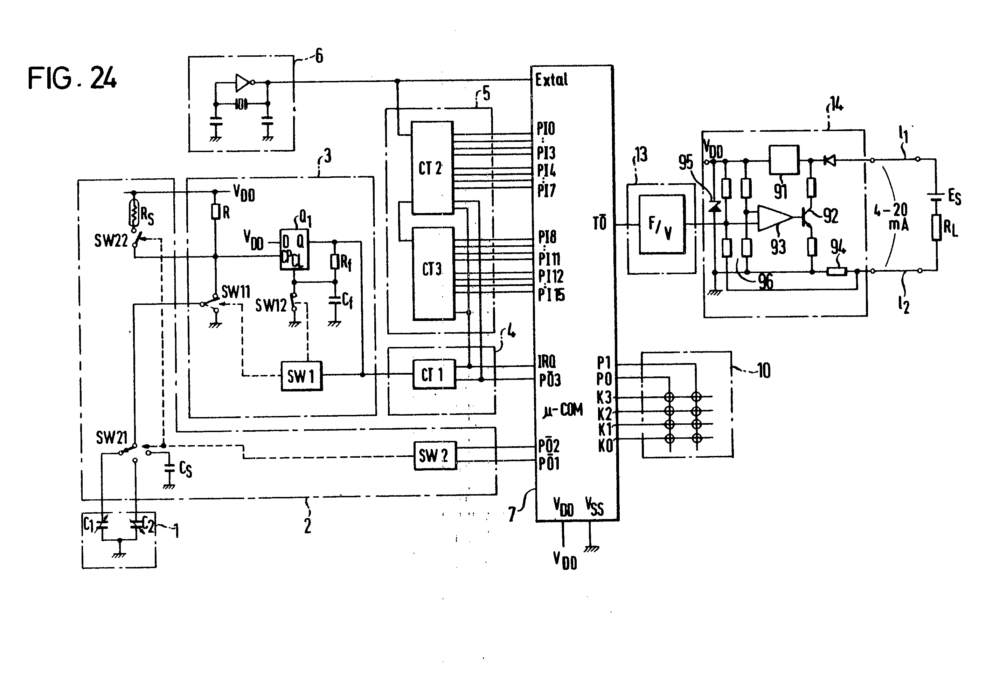

While in the foregoing embodiments optical digital output signals are transmitted from the measurement apparatus, the present invention is applicable to a measurement apparatus for transmitting a current signal indicative of measured data. Such a measurement apparatus will be described with reference to a block diagram of Fig. 23 and a circuit diagram of Fig. 24.

As shown in Fig. 23, the measurement apparatus comprises a detector 1, a detector selector circuit 2, a frequency converter circuit 3, a counter 4, a timer 5, a reference clock generator circuit 6, a microprocessor 7 ("μ-COM processing circuit"), a frequency-to-voltage (F/V) converter circuit 13, a voltage-to-current (V/I) converter and transmitter circuit 14, and a keyboard 10. The components designated at 1—7 and 10 jointly constitute a measuring unit ME and the components designated at 13 and 14 jointly constitute a converter unit CO. The F/V converter circuit and the V/I converter and transmitter circuit may be of known construction.

Data measured as with the foregoing embodiments can be delivered via the frequency-to-voltage (F/V) converter circuit 13 shown in Figs. 23 and 24 to the voltage-to-current (V/I) converter and transmitter circuit 14 which is capable of producing an output current ranging from 4 to 20 mA, from which the data will be transmitted to a remotely located device (load resistor) on the panel. The measuring unit ME (as shown in Fig. 23) has no own power supply and is powered by the V/I converter and transmitter circuit 14 for converting a measured physical quantity in digital form back into a corresponding analog quantity. Such an analog quantity is again converted by the V/I converter circuit 14 into a current in the range of from 4 to 20 mA. Since standardized signals in the range of from 4 to 20 mA are generally used in the art of measurements, the F/V converter circuit 13 and the V/I converter and transmitter circuit 14 are provided for ready cooperation with other measurement equipment and devices on the panel. Therefore, the measurement apparatus as shown first converts an analog quantity into a digital quantity, and then converts the digital quantity back into an analog quantity. The measuring unit for measuring physical quantities is constructed so as to process digital quantities, and hence improves limited measuring accuracies which conventional analog measuring units have suffered from. The measurement apparatus can easily effect various compensational arithmetic operations, and is less influenced by noises or surges with the measuring unit being easily insulated from the voltage-to-current converter circuit.

Although the measuring unit has been shown as producing a frequency signal, it may produce an output signal which has been subjected to pulse-width modulation or other output signals in digital form. The measuring unit may be isolated from a power supply circuit as well as from the voltage-to-current (V/I) converter circuit to increased advantage.

**Claims**

1. A measurement apparatus for converting a physical quantity into a digital quantity and effecting predetermined arithmetic operations based on the digital quantity to measure the physical quantity, comprising a detector (1) and/or a converter (3) for providing a pulse signal dependent on the physical quantity, a counter circuit (5) starting to count clock pulses supplied from a clock signal source (6) when measurement starts, and a digital processing circuit (7) for reading a count in said counter circuit (5) and for effecting predetermined arithmetic operations based on the count from said counter circuit (5) whereby said physical quantity can be measured as a result of said arithmetic operations, characterized in that:

the pulse signal provided by said detector (1) and/or converter (3) has a frequency dependent on the physical quantity,

another counter circuit (4) is provided counting the pulses of said pulse signal and producing a count output when the count reaches a predetermined value,

said clock pulses counting counter circuit (5) stops the clock pulse count in response to the count output from said pulse signal counting counter circuit (4) and

said digital processing circuit (7) reads a count in said clock pulses counting counter circuit (5) in response to the count output from said pulse signal counting counter circuit (4).

2. A measurement apparatus according to claim 1, wherein said detector and/or converter includes a voltage detector (1) for detecting a change in the physical quantity as a voltage change, and a frequency converter circuit (3) having a capacity (C) chargeable by a constant current from a source (CO) of constant current for converting a time requires for a charging voltage for the capacitor to reach said detected voltage change into a pulse signal with a frequency dependent on the detected voltage change.

3. A measurement apparatus according to claim 1, wherein said detector and/or converter includes a measuring resistor (R1) for detecting a change in the physical quantity as a resistance change, and a frequency converter circuit (3) having a capacitor (C) chargeable or dischargeable depending on a current flowing through said measuring resistor to convert a time required for said capacitor to be charged or discharged into a pulse signal with a frequency dependent on said resistance change.

4. A measurement apparatus according to claim 1, wherein said detector and/or converter includes two measuring capacitors (C1, C2), the capacitance of at least one of which is variable depending on a mechanical displacement, and a capacitance-to-frequency converter circuit (3) having a circuit for alternately charging and discharging said two capacitors to convert a time required for the charging and discharging into a pulse signal with a frequency dependent on said capacitance.

5. A measurement apparatus according to any of the preceding claims, including control means for issuing commands for effecting arithmetic operations for a zero point and spanning to said digital processing circuit (7), and memory means for storing the results of arithmetic operations based on operations of the control means, whereby subsequent measured values can be corrected for the zero point and spanning based on the stored data.

6. A measurement apparatus according to claim 1, having a measuring unit (1, 2, 4, 6, 7, 10) and a transmitting unit (8) including an electric-to-optical transducer (LED) to convert the result of measurement into optical information and transmit such optical information to an upper processor, said transmitting unit (8) including an optical-to-electric transducer (PD) for converting optical information received from said upper processor into an electric signal said measuring unit being coupled through said transmitting unit to said upper processor for optical information transmission between said measuring unit and said upper processor.

7. A measurement apparatus according to claim 6, wherein said upper processor is optically coupled with $n$ measuring units through optical divider and coupler means (SC) for optically dividing optical information at a ratio of 1:$n$ and optically coupling optical information at a ratio of $n$:1 for bidirectional transmission of measured optical information through optical transmission

paths (L$_1$, L$_2$, LT$_1$ ... LT$_n$) between said upper processing and said $n$ measuring units on a time-sharing multiplex basis.

8. A measurement apparatus according to claim 6, wherein i) the measurement apparatus includes a source (6) of a clock signal and a digital processing circuit (7) which are supplied with electric power from a built-in battery (9), ii) the measurement apparatus starts predetermined operations upon issuance of a command from an upper processor and then automatically stops its operations, and iii) the measurement apparatus includes a bistable circuit (FF) which can be set by said command from the upper processor and reset in response to completion of the operation of said digital processing circuit (7), and a delay circuit (R$_{SB}$, C$_{SB}$) for delaying an output from said bistable circuit for a predetermined time and for supplying the delayed output to said source (6) of a clock signal, the arrangement being such that when the operation of said digital processing circuit (7) is terminated, a clock signal supplied to said digital processing circuit is delayed for the predetermined time by said delay circuit and is stopped, for thereby de-energizing said digital processing circuit after maintaining a predetermined operating time required for the digital processing circuit to shift into an operation standby condition.

9. A measurement apparatus according to claim 6, including delay means (DL$_1$—DL$_n$) between said transmitting unit (OE$_1$—OE$_n$; EO$_1$—EO$_n$) and said measuring unit (PM$_1$—PM$_n$) for delaying information received by said optical-to-electric transducer for a predetermined time and for transmitting delayed information directly to said electric-to-optical transducer, the arrangement being such that control information supplied from the upper processor is delayed by said delay means for the predetermined time and is sent back so as to detect failures of optical parts in said transmitting unit.

10. A measurement apparatus according to claim 6, including integrating means (CL, RL) for integrating a current flowing through a light-emitting element (LED) in said electric-to-optical transducer (8), the arrangement being such that when the current as integrated by said integrating means reaches a predetermined level, a circuit for lighting said light-emitting element is de-energized to thereby prevent said light-emitting element from being accidentally energized.

11. A measurement apparatus according to claim 6, including optical divider and coupler means (SC), double optical transmission paths (L$_1$, L$_2$) between said upper processor and said optical divider and coupler means, and two pairs of light-emitting (EO11, EO12) and light-receiving elements (OE11, OE12) in said upper processor, the arrangement being such that said light-emitting elements are alternately selected to enable the upper processor to deliver a command to each measurement apparatus (TR1—TRn), and failures can be detected by ascertaining whether information sent back from each measurement apparatus upon said command is received by the light-receiving elements in the upper processor through said optical divider and coupler means and said optical transmission paths, or by checking received information.

12. A measurement apparatus according to claim 6 characterized in that the measurement apparatus has a battery built in it, said battery serving to supply energy to said measuring unit and said transmitting unit.

13. A measurement apparatus according to any of the preceding claims having a transducer unit (13, 14) for converting the result of said arithmetic operations into a current signal within a predetermined range of levels and for delivering the current signal wherein said measurement apparatus is supplied with power from said transducer unit via two-wire-transmission lines having a DC power supply, the current signal from said transducer unit being delivered through said two-wire-transmission lines.

**Patentansprüche**

1. Meßgerät zur Umwandlung einer physikalischen Größe in eine digitale Größe und zur Ausführung vorbestimmter arithmetischer Operationen auf der Basis der digitalen Größe zum Messen der physikalischen Größe, umfassend einen Detektor (1) und/oder einen Umsetzer (3) zur Lieferung eines von der physikalischen Größe abhängenden Impulssignals, eine Zählerschaltung (5), die bei Meßbeginn anfängt, von einer Taktsignalquelle (6) gelieferte Taktimpulse zu zählen, und eine digitale Verarbeitungsschaltung (7) zum Lesen eines Zählerstandes in der Zählerschaltung (5) und zur Ausführung vorbestimmter arithmetischer Operationen auf der Basis des Zählerstandes von der Zählerschaltung (5), wobei die physikalische Größe als Ergebnis dieser arithmetischen Operationen gemessen werden kann,
dadurch gekennzeichnet, daß
das von dem Detektor (1) und/oder Umsetzer (3) gelieferte Impulssignal eine von der physikalischen Größe abhängende Frequenz aufweist,
eine weitere Zählschaltung (4) vorgesehen ist, die die Impulse des Impulssignals zählt und eine Zählausgangssignal erzeugt, wenn der Zählerstand einen vorbestimmten Wert erreicht,
die die Taktimpulse zählende Zählerschaltung (5) als Antwort auf das Zählausgangssignal von der das Impulssignal zählenden Zählerschaltung (4) aufhört, die Taktimpulse zu zählen, und
die digitale Verarbeitungsschaltung (7) als Antwort auf das Zählausgangssignal von der das Impulssignal zählenden Zählschaltung (4) einen Zählerstand in der die Taktimpulse zählenden Zählerschaltung (5) liest.

2. Meßgerät nach Anspruch 1, bei dem der Detektor und/oder Umsetzer einen Spannungsdetektor (1) zur Ermittlung einer Änderung der physikalischen Größe in Form einer Spannungsänderung und eine Frequenzumsetzerschaltung (3) enthält, die einen Kondensator (C) aufweist, der von einem Konstantstrom von einer Quelle (CO) konstanten Stroms aufladbar ist zur Umwandlung der Zeit, die die Ladespannung des Kondensators zum Erreichen der festgestellten Spannungsänderung benötigt, in ein Impulssignal mit einer von der festgestellten Spannungsänderung abhängigen Frequenz.

3. Meßgerät nach Anspruch 1, bei dem der Detektor und/oder Umsetzer einen Meßwiderstand (R1) zur Erfassung einer Änderung der physikalischen Größe in Form einer Widerstandsänderung und eine Frequenzumsetzerschaltung (3) enthält, die einen Kondensator (C) aufweist, der abhängig von einem den Meßwiderstand durchfließenden Strom auf- oder enthladbar ist, damit die zum Aufladen oder Entladen des Kondensators erforderliche Zeit in ein Impulssignal mit einer von der Widerstandsänderung abhängigen Frequenz umgesetzt wird.

4. Meßgerät nach Anspruch 1, bei dem der Detektor und/oder Umsetzer zwei Meßkondensatoren (C1, C2), von denen wenigstens einer eine abhängig von einer mechanischen Verschiebung veränderbare Kapazität besitzt, und eine Kapazitäts-Frequenz-Umsetzerschaltung (3) enthält, die eine Schaltung zum abwechselnden Aufladen und Entladen der beiden Kondensatoren aufweist, um eine für das Aufladen und Entladen erforderliche Zeit in ein Impulssignal mit einer von der Kapazität abhängenden Frequenz umzusetzen.

5. Meßgerät nach einem der vorhergehenden Ansprüche, umfassend eine Steuereinrichtung zur Ausgabe von Befehlen zur Durchführung arithmetischer Operationen für eine Nullpunkt- und Meßbereichseinstellung der digitalen Verarbeitungsschaltung (7) und eine Speichereinrichtung zur Speicherung des Ergebnisses arithmetischer Operationen, die auf Operationen der Steuereinrichtung basieren, wobei nachfolgende Meßwerte in bezug auf Nullpunkt und Meßbereich auf der Basis der gespeicherten Daten korrigiert werden können.

6. Meßgerät nach Anspruch 1 mit einer Meßeinheit (1, 2, 4, 6, 7, 10) und einer Übertragungseinheit (8), umfassend einen elektro-optischen Wandler (LED) zur Umsetzung des Meßergebnisses in optische Information und zur Übertragung der optischen Information an einen übergeordneten Prozessor, wobei die Übertragungseinheit (8) einen opto-elektrischen Wandler (PD) zur Umsetzung von übergeordneten Prozessor empfangener optischer Information in ein elektrisches Signal enthält und die Meßeinheit über die Übertragungseinheit mit dem übergeordneten Prozessor zur Übertragung optischer Information zwischen der Meßeinheit und dem übergeordneten Prozessor gekoppelt ist.

7. Meßgerät nach Anspruch 6, bei dem der übergeordnete Prozessor mit n Meßeinheiten optisch gekoppelt ist, und zwar über eine optische Teiler- und Koppeleinrichtung (SC) zum optischen Teilen optischer Informationen in einerm Verhältnis von 1:n und optischen Koppeln optischer Information in einem Verhältnis von n:1 für eine bidirektionale Übertragung gemessener optische Information über optische Übertragungswege (L$_1$, L$_2$, LT$_1$ ... LT$_n$) zwischen dem übergeordneten Prozessor und den n Meßeinheiten auf einer Zeitmultiplexbasis.

8. Meßgerät nach Anspruch 6, bei dem i) das Meßgerät eine Taktsignalquelle (6) und eine digitale Verarbeitungsschaltung (7) enthält die mit elektrischer Energie aus einer eingebauten Batterie (9) versorgt werden, ii) das Meßgerät auf Grund der Ausgabe eines Befehls vom übergeordneten Prozessor mit vorbestimmten Operationen beginnt und seine Operationen dann automatisch stoppt, und iii) das Meßgerät eine bistabile Schaltung (FF), die von dem Befehl von dem übergeordneten Prozessor gesetzt und als Antwort auf die Vollendung der Operation der digitalen Verarbeitungsschaltung (7) zurückgesetzt werden kann, und eine Verzögerungsschaltung (R$_{SB}$, C$_{SB}$) enthält, die der Verzögerung eines Ausgangssignals von der bistabilen Schaltung für eine vorbestimmte Zeitspanne und der Lieferung des verzögerten Ausgangssignals an die Taktsignalquelle (6) dient, wobei die Anordnung derart ist, daß, wenn die Operation der digitalen Verarbeitungsschaltung (7) abgeschlossen ist, ein an die digitale Verarbeitungsschaltung geliefertes Taktsignal von der Verzögerungsschaltung für die bestimmte Zeitspanne verzögert und dann gestoppt wird, um dadurch die digitale Verarbeitungsschaltung nach Aufrechterhaltung einer vorbestimmten Operationszeit, die die digitale Verarbeitungsschaltung zur Umstellung in einen Betriebsbereitschaftszustand benötigt, abzuschalten.

9. Meßgerät nach Anspruch 6, umfassend eine Verzögerungseinrichtung (DL$_1$—DL$_n$) zwischen der Übertragungseinheit (OE$_1$—OE$_n$, EO$_1$—EO$_n$) und der Meßeinheit (PM$_1$—PM$_n$) zur Verzögerung der von dem opto-elektrischen Wandler empfangenen Information für eine vorbestimmte Zeitspanne und zur Übertragung der verzögerten Information direkt an den elektro-optischen Wandler, wobei die Anordnung so ist, daß von dem übergeordneten Prozessor gelieferte Steuerinformation von der Verzögerungseinrichtung für die vorbestimmte Zeitspanne verzögert und zur Feststellung von Fehlern optischer Teile in der Übertragungseinheit zurückgeschickt wird.

10. Meßgerät nach Anspruch 6, umfassend eine Integriereinrichtung (CL, RL) zum Integrieren eines durch ein lichtemittierendes Element (LED) in dem elektro-optischen Wandler (8) fließenden Stroms, wobei die Anordnung so ist, daß wen der mittels der Integriereinrichtung integrierte Strom einen vorbestimmte Wert erreicht, eine Schaltung, die das licht-emittierende Element in den Leuchtzustand versetzt, abgeschaltet wird, um zu verhindern, daß das licht-emittierende Element versehentlich erregt wird.

11. Meßgerät nach Anspruch 6, umfassend eine optische Teiler- und Koppeleinrichtung (SC), doppelte optische Übertragungswege (L₁, L₂) zwischen dem übergeordneten Prozessor und der optischen Teiler- und Koppeleinrichtung, un zwei Paare licht-emittierender (EO11, EO12) und licht-empfangender Elemente (OE11, OE12) in dem übergeordneten Prozessor, wobei die Anordnung so ist, daß die lichtemittierenden Elemente abwechselnd ausgewählt werden, um dem übergeordneten Prozessor zu ermöglichen, einen Befehl an jedes Meßgerät (TR1—TRn) zu schicken und Fehler dadurch ermittelt werden können, daß festgestellt wird, ob Information, die auf Grund des Befehls von jedem Meßgerät zurückgesandt wird, von den Lichtempfangselementen im übergeordneten Prozessor über die optische Teiler- und Koppeleinrichtung und die optischen Übertragungswege empfangen wird oder dadurch, daß die empfangene Information geprüft wird.

12. Meßgerät nach Anspruch 6, dadurch gekennzeichnet, daß es eine eingebaute Batterie besitzt, die die Meßeinheit und die Übertragungseinheit mit Energie versorgt.

13. Meßgerät nach einem der vorhergehenden Ansprüche mit einer Wandlereinheit (13, 14) zur Umsetzung des Ergebnisses der arithmetischen Operation in ein Stromsignal innerhalb eines bestimmten Wertebereichs und zur Abgabe des Stromsignal, wobei das Meßgerät von der Wandlereinheit über Zwei-Draht-Übertragungsleitungen mit einer Gleichstromquelle mit Energie versorgt wird und das Stromsignal von der Wandlereinheit über die Zwei-Draht-Übertragungsleitungen ausgegeben wird.

**Revendications**

1. Un appareil de mesure destiné à convertir une grandeur physique en une grandeur numérique et à effectuer des opérations arithmétiques prédéterminées basées sur la grandeur numérique pour mesurer la grandeur physique, comprenant un détecteur (1) et/ou un convertisseur (3) destinés à produire un signal sous forme d'impulsions qui dépend de la grandeur physique, un circuit de compteur (5) qui commence à compter des impulsions d'horloge fournies par une source de signal d'horloge (6) lorsque la mesure commence, et un circuit de traitement numérique (7) destiné à lire un compte dans le circuit compteur (5) et à effectuer des opérations arithmétiques prédéterminées basées sur le compte provenant du circuit compteur (5), grâce à quoi on peut mesurer la grandeur physique par le résultat des opérations arithmétiques, caractérisé en ce que le signal sous forme d'impulsions qui est fourni par le détecteur (1) et/ou le convertisseur (3) a une fréquence qui dépend de la grandeur physique, il existe un autre circuit compteur (4) qui compte les impulsions du signal sous forme d'impulsions et qui produit un signal de sortie de comptage lorsque le compte atteint une valeur prédéterminée, le circuit compteur (5) qui compte les impulsions d'horloge arrête le comptage des impulsions d'horloge sous l'effet du signal de sortie de comptage du circuit compteur (4) qui compte le signal sous forme d'impulsions, et le circuit de traitement numérique (7) lit un compte dans le circuit compteur (5) qui compte les impulsions d'horloge, sous la dépendance du signal de sortie de comptage du circuit compteur (4) qui compte signal sous forme d'impulsions.

2. Un appareil de mesure selon la revendication 1, dans lequel le détecteur et/ou le convertisseur comprennent un détecteur de tension (1) destiné à détecter un changement de la grandeur physique sous la forme d'un changement de tension, et un circuit convertisseur de fréquence (3) ayant un condensateur (C) qui peut être chargé par un courant constant provenant d'une source (CO) de courant constant, pour convertir une durée nécessaire pour qu'une tension de charge du condensateur atteigne le changement de tension détecté, en un signal sous forme d'impulsions aynt une fréquence qui dépend du changement de tension détecté.

3. Un appareil de mesure selon la revendication 1, dans lequel le détecteur et/ou le convertisseur comprennent une résistant de mesure (R1) destinée à détecter un changement de la grandeur physique sous la forme d'un changement de résistance, et un circuit convertisseur de fréquence (3) ayant un condensateur (C) qui peut être chargé ou déchargé sous la dépendance d'un courant circular dans la résistance de mesure, pour convertir une durée nécessaire pour la charge ou la décharge du condensateur, en un signal sous forme d'impulsions ayant une fréquence qui dépend du changement de résistance.

4. Un appareil de mesure selon la revendication 1, dans lequel le détecteur et/ou le convertisseur comprennent deux condensateurs de mesure (C1, C2), l'un au moins de ces condensateurs ayant une capacité qui est variable en fonction d'un déplacement mécanique, et un circuit convertisseur capacité-fréquence (3) comportant un circuit destiné à charger et à décharger alternativement les deux condensateurs pour convertir une durée nécessaire pour la charge et la décharge en un signal sour forme d'impulsions ayant une fréquence qui dépend de ladite capacitré.

5. Un appareil de mesure selon l'une quelconque des revendications précédentes, comprenant des moyens de commande destinés à émettre vers le circuit de traitement numérique (7) des ordres destinés à l'accomplissement d'opérations arithmétiques pour le zéro et la valeur de pleine échelle, et des moyens de mémoire destinés à enregistrer les résultats d'opérations arithmétiques basées sur des actions des moyens de commande, ce que permet d'effectuer des corrections de zéro et de valeur de pleine échelle pour des valeurs mesurées ultérieurement, sur la base des données enregistrées.

6. Un appareil de mesure selon la revendication 1, comportant une unité de mesure (1, 2, 4, 6, 7, 10), et un unité de transmission (8) comprenant un transducteur électrique-optique (LED) destiné à convertir le résultat de mesure en une information optique et à transmettre cette information optique vers un processeur de niveau supérieur, cette unité de transmission (8) comprenant un transducteur optique-électrique (PD) destiné à convertir en un signal électrique l'information optique reçue à partir du processeur de niveau supérieur, et l'unité de mesure étant reliée par l'unité de transmission au processeur de niveau supérieur, pour la transmission d'information optique entre l'unité de mesure et le processeur de niveau supérieur.

7. Un appareil de mesure selon la revendication 6, dans lequel le processeur de niveau supérieure est en couplage optique avec $n$ unités de mesure par l'intermédiaire de moyens diviseurs et coupleurs optiques (SC) destinés à diviser optiquement l'information optique dans un rapport de 1:n et à coupler optiquement l'information optique dans un rapport de n:1, pour la transmission bidirectionnelle de l'information optique mesurée, dans des voies de transmission optique $(L_1, L_2, LT_1 \ldots LT_n)$, entre le processeur de niveau supérieur et les $n$ unités de mesure, en multiplex temporel.

8. Un appareil de mesure selon la revendication 6, dans lequel i) l'appareil de mesure comprend une source (6) de signal d'horloge et un circuit de traitement numérique (7) qui sont alimentées en énergie électrique à partir d'une batterie incorporée (9), ii) l'appareil de mesure commence à accomplir des opérations prédéterminées à l'émission d'un ordre provenant d'un processeur de niveau supérieur, et il arrête automatiquement ses opérations, et iii) l'appareil de mesure comprend un circuit bistable (FF) qui peut être instauré par l'ordre provenant du processeur de niveau supérieur et restauré sous l'effet de l'achèvement de l'opération du circuit de traitement numérique (7), et un circuit de retard $(R_{SB}, C_{SB})$ destiné à retarder d'une durée prédéterminée un signal de sortie du circuit bistable, et à appliquer le signal de sortie retardé à la source (6) de signal d'horloge, la configuration étant telle que lorsque l'opération du circuit de traitement numérique (7) est terminée, un signal d'horloge qui est appliqué à ce circuit de traitement numérique est retardé de la durée prédéterminée par le circuit de retard puis est arrêté, grâce à quoi le circuit de traitement numérique est mis hors fonction au bout d'une durée prédéterminée nécessaire pour que le circuit de traitement numérique passe dans une condition de fonctionnement d'attente.

9. Un appareil de mesure selon la revendication 6, comprenant des moyens de retard $(DL_1—DL_n)$ entre l'unité de transmission $(OE_1—OE_n, EO_1—EO_n)$ et l'unité de mesure $(PM_1—PM_n)$, destinés à retarder d'une durée prédéterminée l'information reçue par le transducteur optique-électrique, et à émettre directement l'information retardée vers le transducteur électrique-optique, la configuration étant telle que l'information qui provient du processeur de niveau supérieur est retardée de la durée prédéterminée par les moyens de retard et est renvoyée de façon à détecter des défauts dans des parties optiques de l'unité de transmission.

10. Un appareil de mesure selon la revendication 6, comprenant des moyens d'intégration (CL, RL) destinés à intégrer un courant qui circule dans un élément émetteur de lumière (LED) dans le transducteur électrique-optique (8), avec une configuration telle que lorsque le courant qui est intégré par les moyens d'intégration atteint un niveau prédéterminé, un circuit destiné à éclairer l'élément émetteur de lumière est mis hors fonction, pour éviter ainsi que l'élément émetteur de lumière ne soit mis en fonction accidentellement.

11. Un appareil de mesure selon la revendication 6, comprenant des moyens diviseurs et coupleurs optiques (FC), des voies de transmission optiques doubles $(L_1, L_2)$ entre le processeur de niveau supérieur et les moyens diviseurs et coupleurs optiques, et deux paires d'éléments émetteurs de lumière (EO11, EO12) et récepteurs de lumière (OE11, OE12) dans le processeur de niveau supérieur, avec une configuration telle quel les éléments émetteurs de lumière sont alternativement sélectionnés pour permettre au processeur de niveau supérieur d'émettre un order vers chaque appareil de mesure (TR1—TRn), et il est possible de détecter des défauts en déterminant si l'information renvoyée par chaque appareil de mesure lorsque l'ordre précite est émis, est reçue par les éléments récepteurs de lumière dans le processeur de niveau supérieur, par l'intermédiaire des moyens diviseurs et coupleurs optiques et des voies de transmission optiques, ou en contrôlant l'information reçue.

12. Un appareil de mesure selon la revendication 6, caractérisé en ce que cet appareil de mesure comporte une batterie incorporée, et cette batterie alimente en énergie l'unité de mesure et l'unité de transmission.

13. Un appareil de mesure selon l'une quelconque des revendications précédentes, comprenant un dispositif transducteur (13, 14) destiné à convertir le résultat des opérations arithmétiques en un signal de courant dans une plage de niveau prédéterminée, et à fournir le signal de courant, et cet appareil de mesure est alimenté en énergie, par l'intermédiaire de lignes de transmission bifilaires, à partir du dispositif transducteur qui comporte une alimentation à courant continu, et le signal de courant provenant du dispositif transducteur est fourni par l'intermédiaire de ces lignes de transmission bifilaires.

# FIG.1

# FIG.2A

# FIG.2B

# FIG . 3

FIG. 4

0 071 912

## FIG. 5

FIG. 6

0 071 912

FIG.7

ZERO MEASUREMENT MODE ←——→ E₁ MEASUREMENT MODE

(a)

(b)   (RESET RELEASED)   (RESET RELEASED)

(c)

(d)

(e)

(f)

(g)

0 071 912

FIG. 8

FIG. 9

FIG . 10

V_DD

R_L

R_1

R_L    R_L    R_c

(T_1)    (T_2)

SW2    (T_3)

SW 11

C

Q1

FLIP-
FLOP

FIG .11 A

F

Δd

R_2    R_1

OB

FIG . 11 B

V_DD    V_DD

R_1    (T_1)    (T_2)    R_2

SW2

SW 11

C

Q1

FLIP-
FLOP

FIG . 12

# FIG.13

# FIG . 14

CE

CPU

CO

TRANSDUCER

OFS

SC

COUPLER

OFM

TR

TR$_1$

TR$_2$

TR$_n$

PANEL ← | → FIELD

## FIG.15

CS

(a)

| D_0 | D_1 | D_2 | D_3 | D_4 | D_5 | D_6 | D_7 |

ST   AD   MO   AU   PA

(b)

ST   CS          ST   ZE          SP

(c)

ST   CS    DA

(d)

ST   CS    ZE    SP

## FIG.16

(a)  CS_1        CSK

$\tau$

(b)  (TR1)       (TRK)

$\tau_1$

(c)          (TR 1)

$\tau_2$

(d)          (TRK)

$\tau_3$

## 0 071 912

# FIG . 17

① ( INTERRUPT )

② | DETECT SERIAL INPUT |

③ < ADDRESSED? > ——NO

↓ YES

④ < MEASUREMENT MODE? > ——NO

↓ YES

⑤ | TRANSMIT DATA OUTPUT SERIALLY |

⑥ | MEASURE $T_1$ |

⑦ | MEASURE $T_2$ |

⑧ | EFFECT ARITHMETIC OPERATIONS |

⑨ | CORRECT ZERO POINT AND SPANNING |

⑩ | CORRECT ZERO POINT AND SPANNING FOR TEMPERATURE COMPENSATION |

⑪ | ADJUST RANGE |

⑫ | COMPENSATE FOR DAMPING |

⑬ | ENTER TEMPERATURE MEASUREMENT MODE |

⑭ | ENTER VOLTAGE MEASUREMENT MODE |

⑮ < IS INPUT SIGNAL APPLIED ? > ——NO

↓ YES

⑯ | MAINTAIN TIME FOR TIMER RANGE SETTING |

⑰ ( WAIT FOR INTERRUPT )

⑱ | READ SERIAL INPUT FOR RANGE CHANGE |

⑲ | OUTPUT RANGE SIGNAL |

14

# FIG. 18

(a)

ST

(b)

(STANDBY RELEASED)

$R_e$

(c)

t

(d)

t

# FIG. 19

(A)

ST

ST

CS

(B)

(STANDBY RELEASED)

$H_1$

t

t

(C)

(STANDBY RELEASED)

$H_2$

t

t

# FIG . 20

FIG. 21

# FIG. 22

PANEL | FIELD

# FIG . 23

DETECTOR 1 → SELECTOR CIRCUIT 2 → FREQUENCY CONVERTER 3 → COUNTER 4 → TIMER 5 → μ-COM 7 → F/V-CONVERTER 13 → V/I-CONVERTER +TRANSMITTER 14 → OUTPUT (4-20mA)

CLOCK GENERATOR 6

KEYBOARD 10

MEASURING UNIT | CONVERTER UNIT

0 071 912

FIG. 24

0 071 912